(19) Europäisches Patentamt
European Patent Office
Office européen des brevets

(11) **EP 4 773 181 A1**

(12) **EUROPEAN PATENT APPLICATION**
published in accordance with Art. 153(4) EPC

(43) Date of publication:
08.07.2026 Bulletin 2026/28

(51) International Patent Classification (IPC):
*H01L 21/683* (2006.01)  *H02N 13/00* (2006.01)
*H10K 59/10* (2023.01)  *H10K 59/95* (2026.01)
*H10K 71/00* (2023.01)

(21) Application number: 24859834.4

(22) Date of filing: 28.08.2024

(52) Cooperative Patent Classification (CPC):
H02N 13/00; H10K 59/10; H10K 59/95;
H10K 71/00; H10P 72/30; H10P 72/70

(86) International application number:
PCT/JP2024/030734

(87) International publication number:
WO 2025/047804 (06.03.2025 Gazette 2025/10)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 30.08.2023  JP 2023140333
20.08.2024  JP 2024139159

(71) Applicant: Institute of Science Tokyo
Tokyo 152-8550 (JP)

(72) Inventors:
• SAITO, Shigeki
Tokyo 152-8550 (JP)
• YOSHIMOTO, Jumpei
Tokyo 152-8550 (JP)
• TAOKA, Yuki
Tokyo 152-8550 (JP)

(74) Representative: Gille Hrabal
Partnerschaftsgesellschaft mbB
Patentanwälte
Brucknerstraße 20
40593 Düsseldorf (DE)

(54) **ELECTROSTATIC ADSORPTION DEVICE, WARP CORRECTION METHOD, AND MOUNTING METHOD**

(57) Provided are an electrostatic adsorption device with enhanced curved surface adaptation capability and a warp correction method and mounting method using the same.

An electrostatic adsorption device for electrostatically adsorbing an object to be adsorbed is provided. The electrostatic adsorption device includes a structural body and an electrode member. The structural body is configured to be at least partially deformed to form a curved portion. The curved portion is curved from one side to another side in a first direction. The first direction is parallel to a plane perpendicular to a thickness direction of the structural body. The electrode member is disposed to be at least partially covered by the structural body and has an adsorption surface for electrostatically adsorbing the object to be adsorbed. In a curved state in which the curved portion is formed in the structural body, the adsorption surface of the electrode member is located in a corresponding position along the curved portion.

FIG.1A

EP 4 773 181 A1

FIG.1B

100

## Description

TECHNICAL FIELD

The present invention relates to an electrostatic adsorption device, warp correction method, and mounting method.

BACKGROUND ART

Patent Literature 1 discloses an electrostatic adsorption device (electrostatic chuck) that adsorbs and holds a substrate (an object to be adsorbed) whose adsorbed surface is flat. This electrostatic adsorption device adsorbs and releases the object using an electrostatic force that acts between the device and the object when a voltage is applied. In other words, the electrostatic adsorption device is able to adsorb the object to be adsorbed by making a potential difference between itself and the object using electrodes.

Citation List

Patent Literature

[Patent Literature 1] Japanese Unexamined Patent Application Publication No. 2007-109827

SUMMARY OF THE INVENTION

Problem to be Solved by the Invention

There is a concern that when the adsorbed surface of the object is not flat, the electrostatic adsorption device of Patent Literature 1 may not be able to properly adsorb the object.

An object of the present invention is to provide an electrostatic adsorption device with enhanced curved surface adaptation capability (capability to properly adsorb the object to be adsorbed even when the adsorbed surface of the object is curved) and a warp correction method and mounting method using the same.

Means for Solving the Problem

An electrostatic adsorption device according to the present invention is an electrostatic adsorption device for electrostatically adsorbing an object to be adsorbed. The electrostatic adsorption device includes a structural body and an electrode member. The structural body is configured to be at least partially deformed to form a curved portion. The curved portion is curved from one side to another side in a first direction. The first direction is parallel to a plane perpendicular to a thickness direction of the structural body. The electrode member is disposed to be at least partially covered by the structural body and has an adsorption surface for electrostatically adsorbing the object to be adsorbed. In a curved state in which the curved portion is formed in the structural body, the adsorption surface of the electrode member is located in a corresponding position along the curved portion.

In the electrostatic adsorption device according to the present invention, the electrode member is disposed to be at least partially covered by the structural body configured to form the curved portion. That is, the electrode member is disposed integrally with the structural body. Thus, in response to the curved portion being formed in the structural body (in response to the structural body being placed in the curved state), the electrode member moves and its adsorption surface is located in the corresponding position along the curved portion. As a result, the electrostatic adsorption device according to the present invention is able to locate the adsorption surface of the electrode member in a position along the curved surface of the object to be adsorbed corresponding to the curve of the curved portion, that is, has enhanced curved surface adaptation capability.

BRIEF DESCRIPTION OF THE DRAWINGS

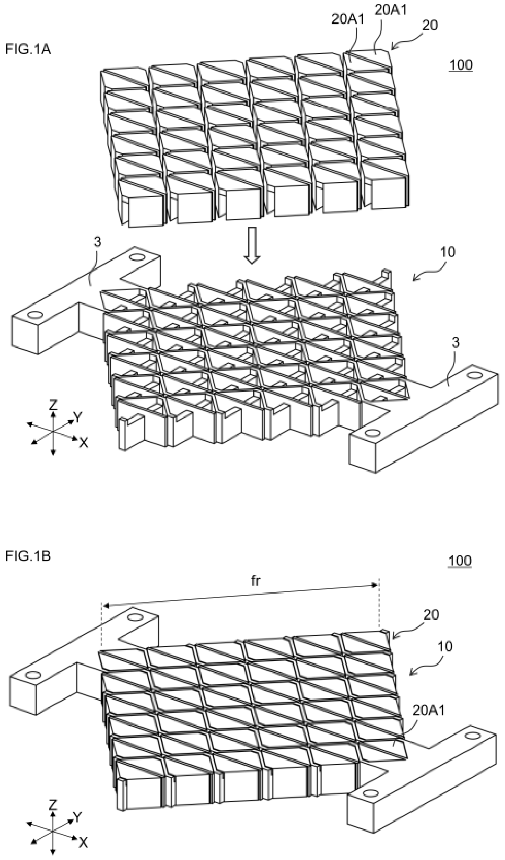

FIG. 1A is an exploded perspective view of an electrostatic adsorption device 100 according to an embodiment, and FIG. 1B is a perspective view of the electrostatic adsorption device 100 shown in FIG. 1A. FIGS. 1A and 1B are perspective views of the adsorption surface side of the electrostatic adsorption device 100.

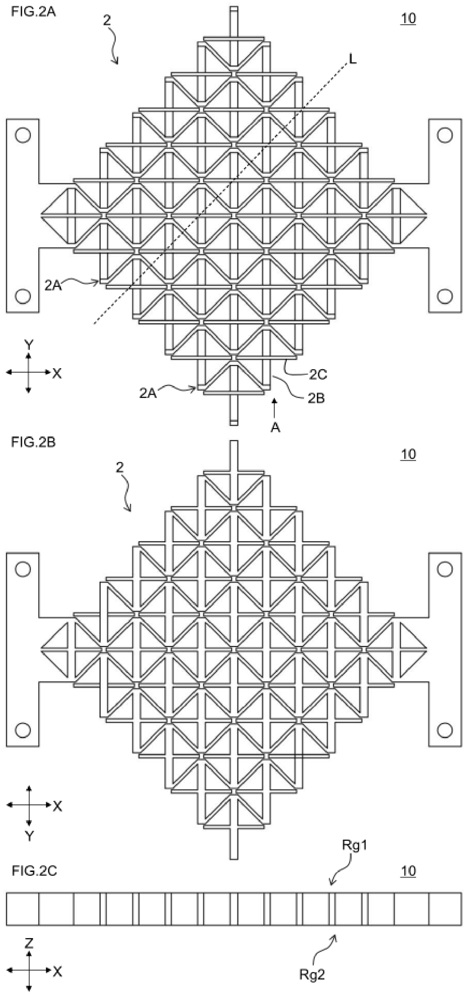

FIG. 2A is a plan view of a structural body 10 shown in FIG. 1A as seen from the adsorption surface side of the electrostatic adsorption device 100. FIG. 2B is a plan view of the structural body 10 shown in FIG. 2A as seen from a side opposite to that in FIG. 2A. FIG. 2C is a side view of the structural body 10 shown in FIG. 2A as seen from a direction corresponding to an arrow A.

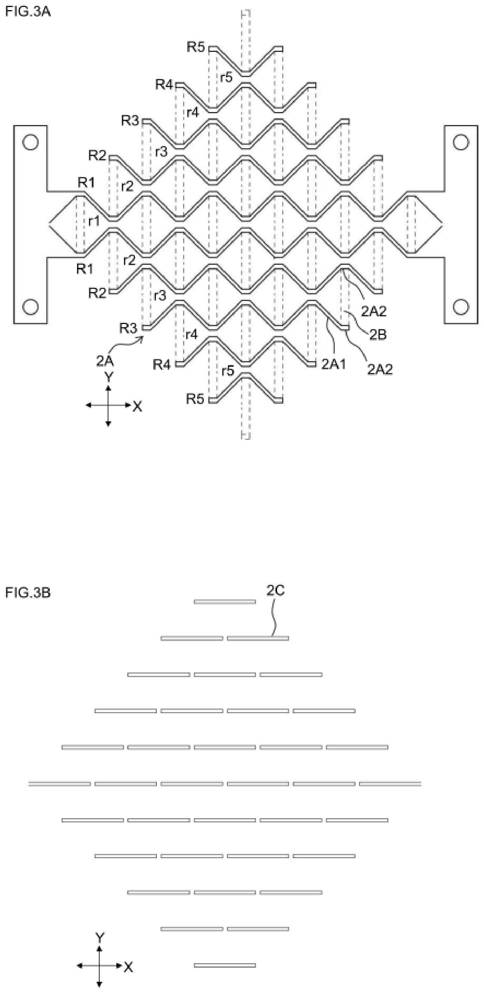

FIG. 3A schematically shows first plate-shaped portions 2A using solid lines and second plate-shaped portions 2B using dashed lines so that the components of the structural body 10 shown in FIG. 2A are easily distinguished from each other. For convenience's sake, third plate-shaped portions 2C are not shown in FIG. 3A. FIG. 3B is an extracted view of the third plate-shaped portions 2C, which are components of the structural body 10 shown in FIG. 2A.

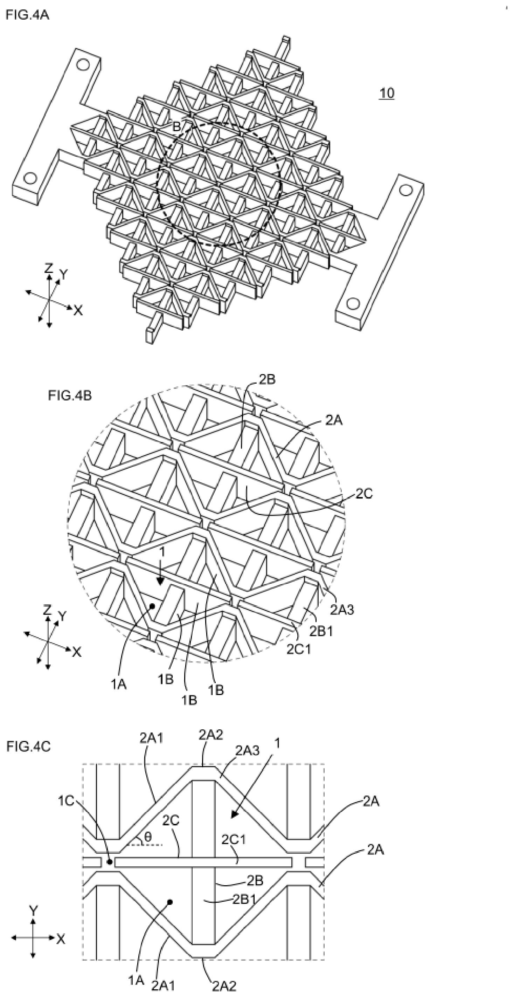

FIG. 4A is a perspective view of the structural body 10 shown in FIG. 2A, FIG. 4B is an enlarged view of an area B shown in FIG. 4A. FIG. 4C is an enlarged view of the structural body 10 shown in FIG. 2A.

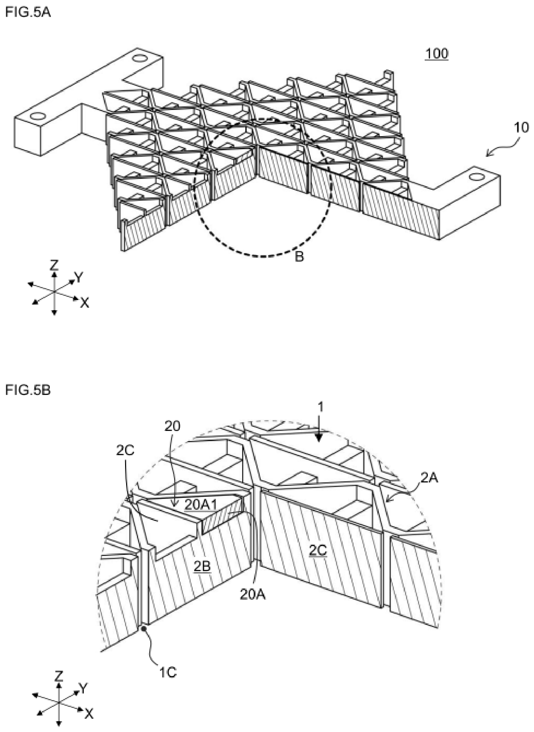

FIG. 5A is a perspective view of a state in which one electrode member 20 is located approximately at the center of the structural body 10, and FIG. 5B is an enlarged view of an area B shown in FIG. 5A.

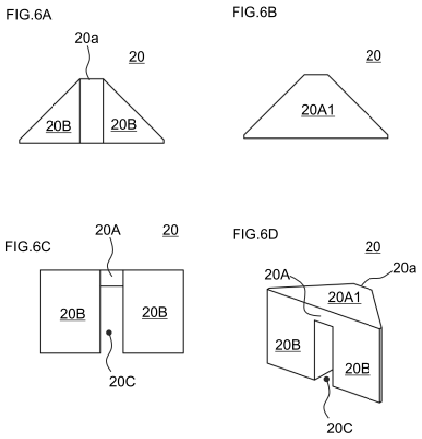

FIG. 6A is a bottom view of an electrode member 20 (a view from a side opposite to an adsorption surface 20A1). FIG. 6B is a top view of the electrode member 20 (a view from the adsorption surface 20A1 side). FIG. 6C is a front view of the electrode member 20. FIG. 6D is a perspective view of the electrode member 20.

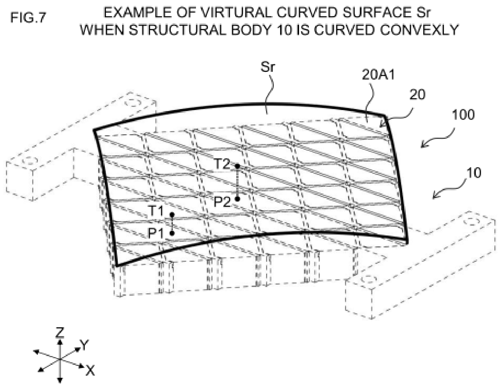

FIG. 7 is a diagram showing movement of the position of the adsorption surface of the electrode member 20 when the electrostatic adsorption device 100 makes a transition from a flat state to a curved state. For convenience's sake, FIG. 7 shows the electrostatic adsorption device 100 using dashed lines and a virtual surface Sr using a solid line.

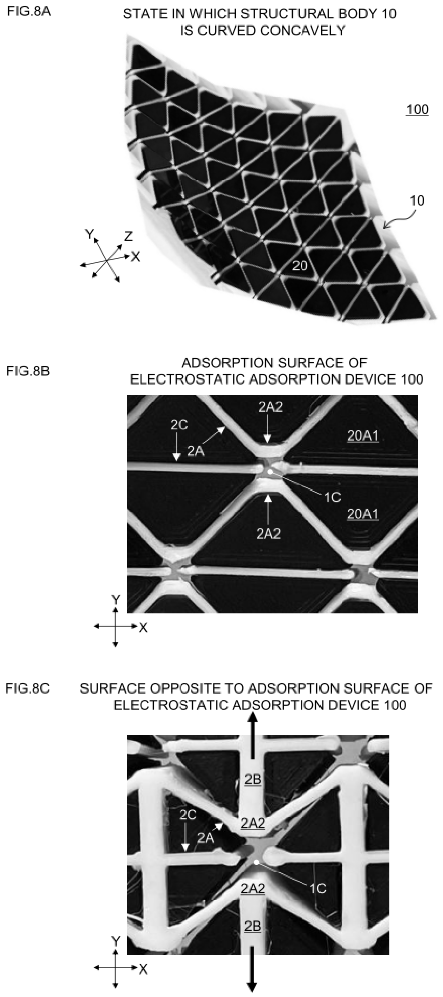

FIG. 8A is a perspective view of the electrostatic adsorption device 100 in the curved state. FIG. 8B is an enlarged view of the adsorption surface of the electrostatic adsorption device 100 shown in FIG. 8A. FIG. 8C is an enlarged view of a surface opposite to the adsorption surface of the electrostatic adsorption device 100 (a surface opposite to that shown in FIG. 8B).

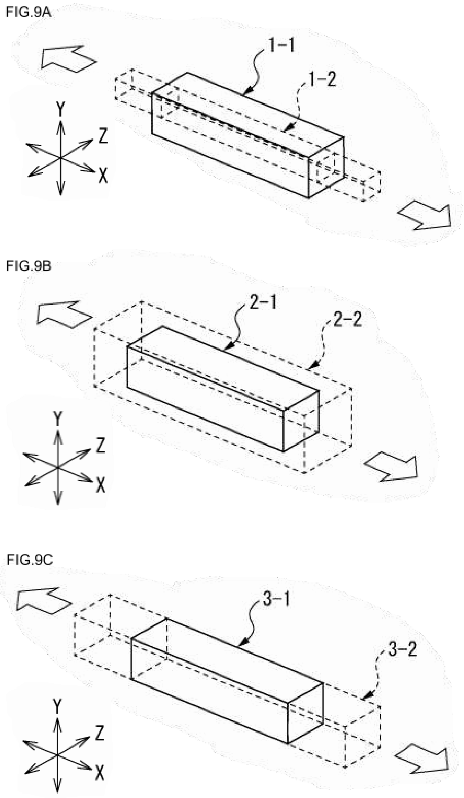

FIGS. 9A to 9C are diagrams showing the relationship between tensile stress and Poisson's ratio.

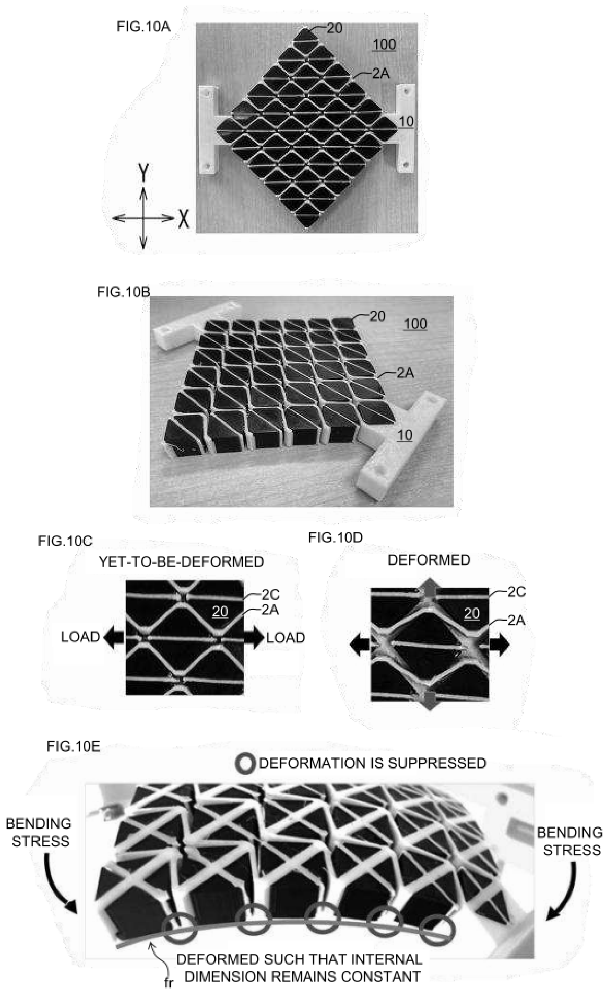

FIG. 10A is a plan view of a prototyped electrostatic adsorption device 100 as seen from the adsorption surface side. FIG. 10B is a perspective view of the electrostatic adsorption device 100 shown in FIG. 10A. FIG. 10C is an enlarged view showing the state (flat state) of the yet-to-be-deformed structural body 10 of the electrostatic adsorption device shown in FIG. 10A, and FIG. 10D is an enlarged view showing the state (curved state) of the deformed structural body 10. FIG. 10E is a perspective view showing the state (curved state) of the deformed structural body 10 of the electrostatic adsorption device shown in FIG. 10A.

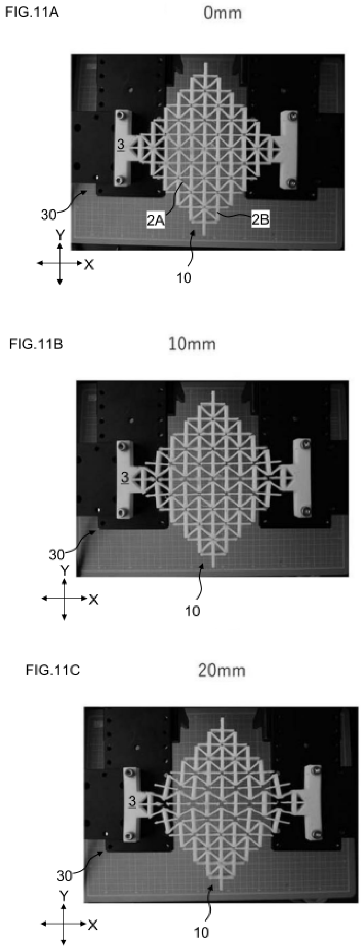

FIG. 11A is a diagram showing a state in which horizontal tensile stress has yet to be applied to the structural body 10 shown in FIG. 10A. FIG. 11B is a diagram showing a state in which the structural body 10 shown in FIG. 11A has been extended horizontally by 10 mm by undergoing horizontal tensile stress. FIG. 11C is a diagram showing a state in which the structural body 10 in the state shown in FIG. 11B has been extended horizontally by 20 mm by further undergoing horizontal tensile stress.

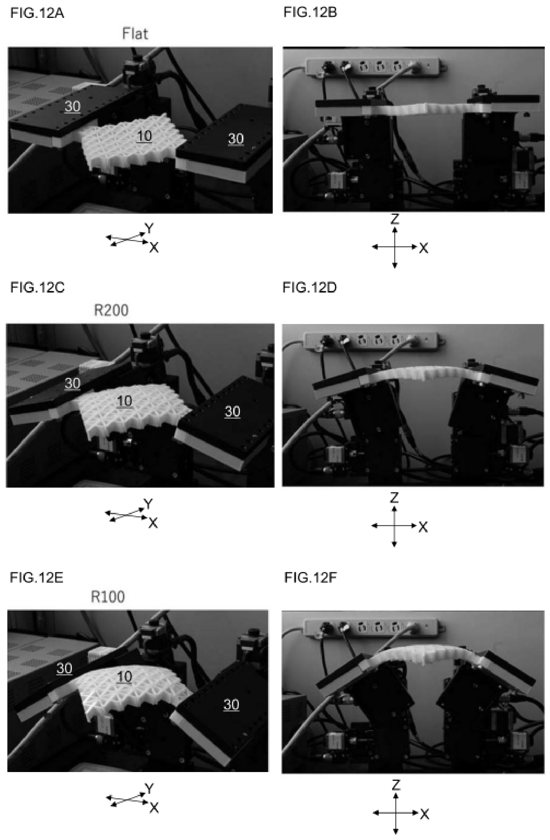

FIGS. 12A and 12B show a state in which the structural body 10 shown in FIG. 10A has yet to undergo bending stress. The viewing angle varies between FIGS. 12A and 12B. FIGS. 12C and 12D show a state in which the structural body 10 shown in FIG. 12A has undergone bending stress to form a curved portion having a virtual surface with a curvature radius of R200 mm (see FIG. 7). The viewing angle varies between FIGS. 12C and 12D. FIGS. 12E and 12F show a state in which the structural body 10 shown in FIG. 12B has been further curved such that the curvature radius of the virtual surface of the curved portion becomes R100 mm. The viewing angle varies between FIGS. 12E and 12F.

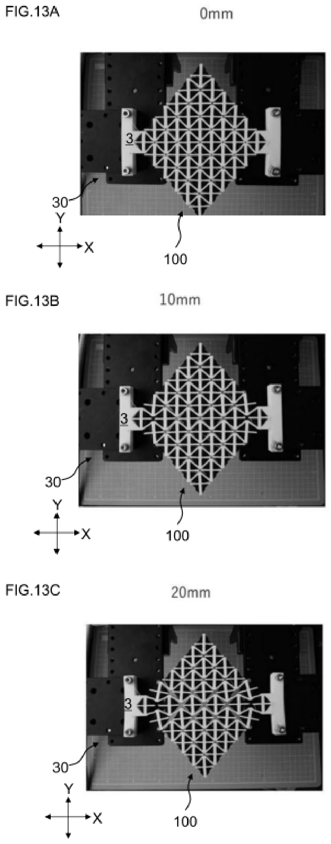

FIGS. 13A to 13C are drawings corresponding to FIGS. 11A to 11C, respectively. The electrode members 20 are disposed on the structural body 10 in FIGS. 13A to 13C; the electrode members 20 are not disposed on the structural body 10 in FIGS. 11A to 11C.

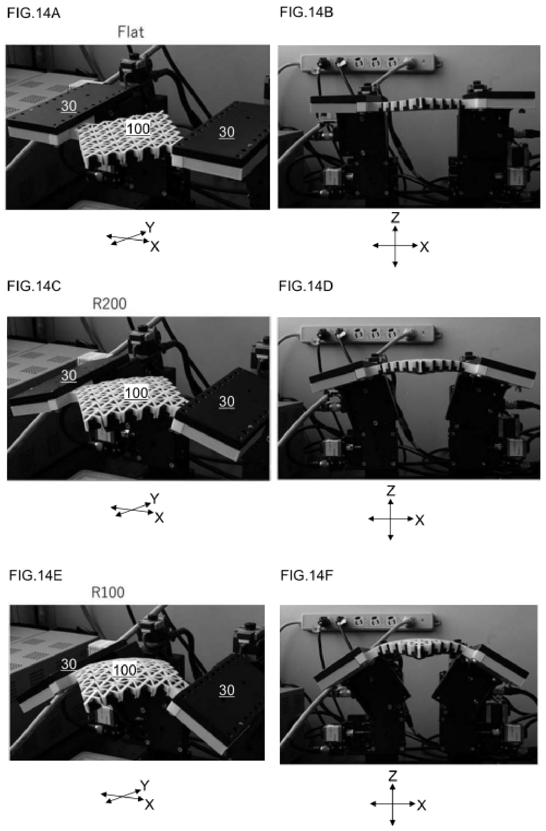

FIGS. 14A to 14F are drawings corresponding to FIGS. 12A to 12F, respectively. The electrode members 20 are disposed on the structural body 10 in FIGS. 14A to 14F; the electrode members 20 are not disposed on the structural body 10 in FIGS. 12A to 12F.

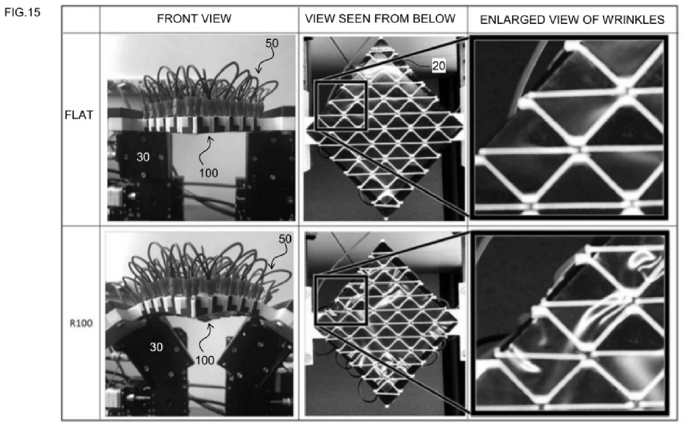

FIG. 15 includes drawings showing the state of a film adsorbed by the electrostatic adsorption device 100.

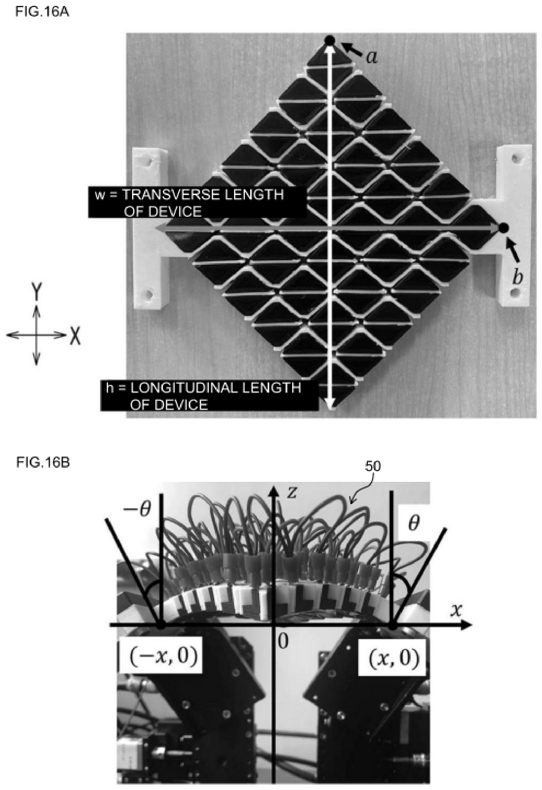

FIGS. 16A and 16B are drawings showing a calculation formula for curving (deforming) an auxetic structural body while keeping constant the internal dimension of the peripheral edge thereof.

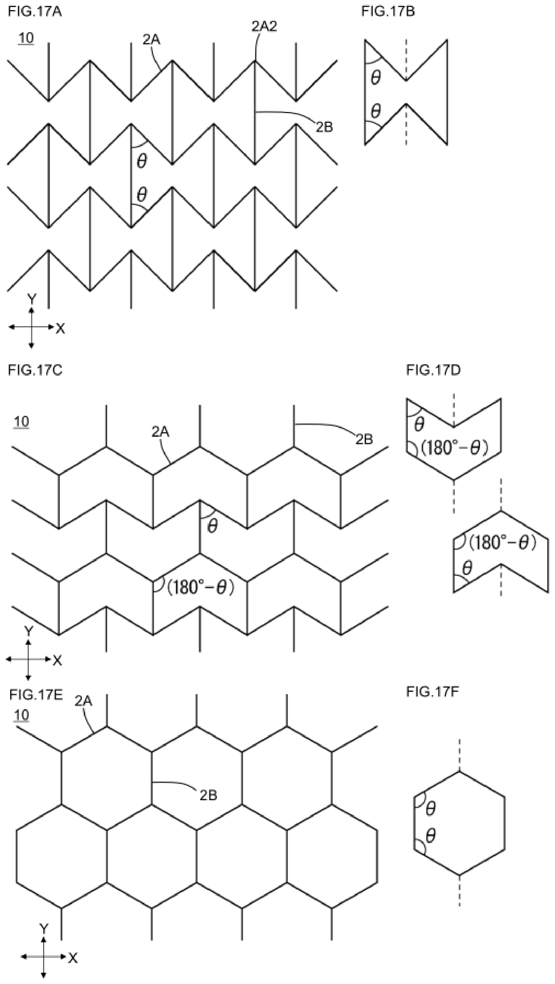

FIGS. 17A and 17B are schematic diagrams showing a modification 1-1 of the structural body 10. FIGS. 17C and 17D are schematic diagrams showing a modification 1-2 of the structural body 10. FIGS. 17E and 17F are schematic diagrams showing a modification 1-3 of the structural body 10.

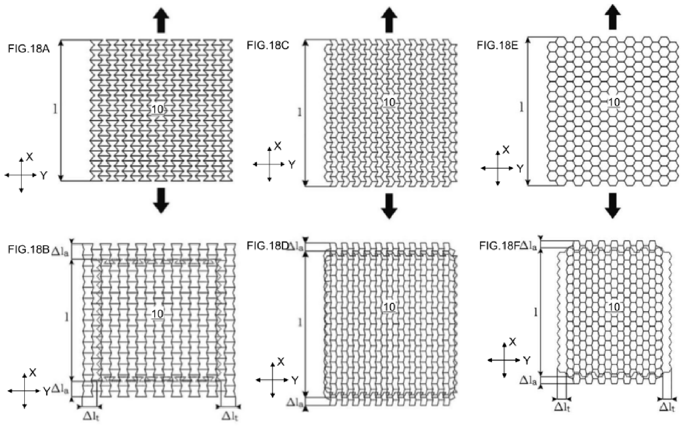

FIGS. 18A and 18B are diagrams showing a process in which the structure of the modification 1-1 shown in FIGS. 17A and 17B is deformed. FIGS. 18C and 18D are diagrams showing a process in which the structure of the modification 1-2 shown in FIGS. 17C and 17D is deformed. FIGS. 18E and 18F are diagrams showing a process in which the structure of the modification 1-3 shown in FIGS. 17E and 17F is deformed.

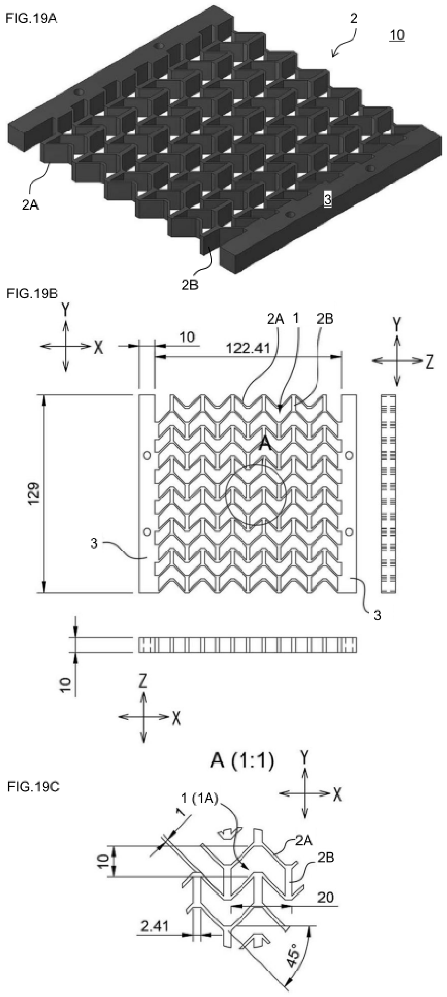

FIG. 19A is a perspective view showing a structural body 10 corresponding to the modification 1-2. FIG. 19B shows a plan view and a side view of the structural body 10 shown in FIG. 19A. FIG. 19C is an enlarged view of an area A shown in FIG. 19B.

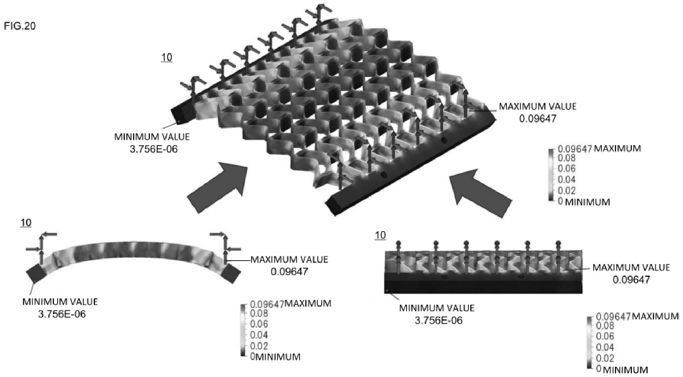

FIG. 20 shows a process in which the structural body 10 shown in FIGS. 19A to 19C is curved (deformed).

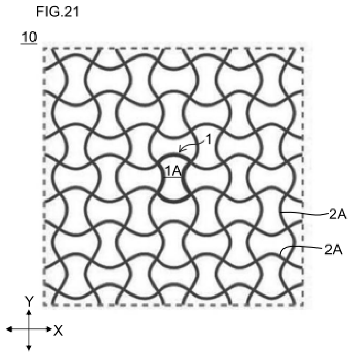

FIG. 21 is a plan view showing a structural body 10 according to a modification 1-4.

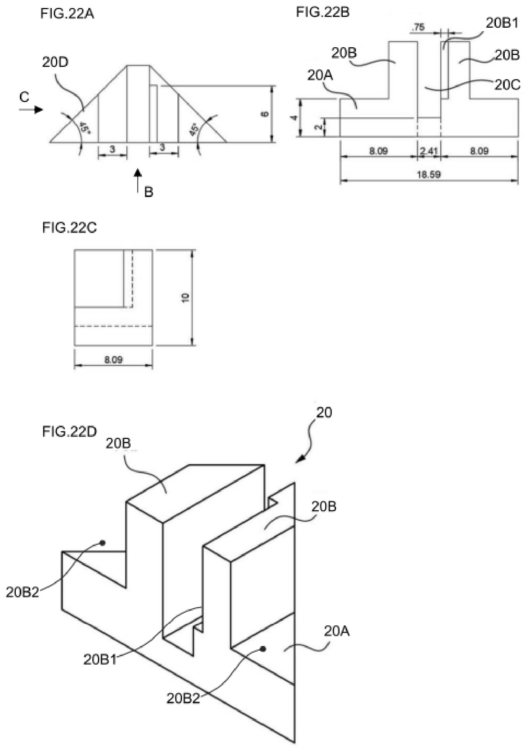

FIG. 22A is a bottom view of an electrode member 20 according to a modification (a view from a side opposite to the adsorption surface). FIG. 22B is a side view as seen from the direction of an arrow B shown in FIG. 22A. FIG. 22C is a side view as seen from the direction of an arrow C shown in FIG. 22A. FIG. 22D is a perspective view of the electrode member according to the modification.

DESCRIPTION OF EMBODIMENTS

An embodiment of the present invention will be described below with reference to the drawings. Various features described in the embodiment below can be combined with each other. Each feature independently establishes the present invention. Note that dimensions provided in the drawings are merely example dimensions in the embodiment and modifications and are not intended to be limiting.

1. Configuration of Embodiment

An electrostatic adsorption device 100 according to the present embodiment shown in FIGS. 1A and 1B is configured to electrostatically adsorb an object to be adsorbed. In particular, the electrostatic adsorption device 100 is suitable to electrostatically adsorb an object to be adsorbed having a curved surface. Examples of the object to be adsorbed include a wafer and a film. While, in the present embodiment, the electrostatic adsorption device 100 is described assuming that the object to be adsorbed is a wafer or film, the object does not have to be a wafer or film. The electrostatic adsorption device 100 may be used to adsorb any other object having a curved surface.

The types of electrostatic chucks (electrostatic adsorption devices) include various types, such as Coulomb type, Johnsen-Rahbek type, and gradient type. The electrostatic adsorption device 100 according to the present embodiment can be applied to, for example, these types.

An x-direction, a y-direction, and a z-direction shown in the drawings are perpendicular to each other. The x-direction is an example of the first direction, and the y-direction is an example of the second direction intersecting the first direction. The x-direction and y-direction are directions parallel to a plane perpendicular to the thickness direction of the structural body 10 of the electrostatic adsorption device 100 according to the present embodiment. The z-direction is the thickness direction of the structural body 10.

1-1. Structural body 10

The structural body 10 is made of a resin material or metal material. The resin material is preferably a material having moderate elasticity and capable of ensuring the insulation between electrode members 20 (to be described later). Examples of the resin material include polyurethane resin, polyamide resin, polyimide resin, acrylate resin, and the like. Examples of the metal material include stainless steel and the like. The material to be used may vary among the members of the structural body 10. For example, first plate-shaped portions 2A (to be described later) may be made of polyurethane resin to have a higher degree of elasticity, while second plate-shaped portions 2B (to be described later) may be made of polyamide resin, polyimide resin, or acrylate resin to have a lower degree of elasticity. If the structural body 10 is made of a conductive material, it is preferable to ensure insulation using a method, such as disposition of an insulating film in the structural body 10 or disposition of an insulating film on the electrode members 20 themselves.

While, in the structural body 10 according to the present embodiment, the overall shape of an area forming each housing portion 1 is a rhombus, this is not limiting. For example, the overall shape may be a polygonal shape other than a rhombus. The ratio between the dimension in the x-direction and that in the y-direction is arbitrary. While the structural body 10 can be produced using, for example, a 3D printer, this method is not limiting.

1-1-1. Housing portion 1

As shown in FIGS. 4A and 4B, the structural body 10 includes multiple housing portions 1. Each housing portion 1 includes a cavity 1A and partition walls 1B. The cavity 1A contains electrode members 20. The partition walls 1B partitions the adjacent cavity 1A.

As shown in FIGS. 1A, 1B, 4A, and 4B, partition walls 1B are disposed to surround the lateral side of each electrode member 20. This can avoid the contact between adjacent electrode members 20 and insulate them from each other. Note that the partition walls 1B do not necessarily have to cover the entire lateral side of the electrode member 20.

Each cavity 1A consists of a space that can contain electrode members 20. In one embodiment, a cavity 1A has a rhombic shape in a plan view, as shown in FIG. 4C. The space of each cavity 1A is divided by a third plate-shaped portion 2C (to be described later). Two electrode members 20 can be inserted into the cavity 1A. While, in the present embodiment, the space of each cavity 1A is divided into two portions by a third plate-shaped portion 2C, it may be divided into three or more portions. In other words, not two but three or more electrode members 20 may be inserted into each cavity 1A. A single electrode member 20 may be inserted into each of cavities 1A whose space is not divided.

The multiple cavities 1A are arranged to form a plane. Specifically, the multiple cavities 1A are arranged in the x-direction, as well as in the y-direction. As seen above, the x-direction and y-direction are directions in which the electrode members 20 and the cavities 1A (housing portions 1) are arranged. While, in the present embodiment, the directions in which the electrode members 20 and the cavities 1A (housing portion 1) are arranged (i.e., the x-direction and y-direction) are perpendicular to each other (form a 90-degree angle), this is not limiting. The directions only have to intersect each other.

As seen above, the structural body 10 can contain the multiple (e.g., 36 in one embodiment) electrode members 20 such that the electrode members 20 are arranged to form a plane. In other words, since the cavities 1A are two-dimensionally disposed in the structural body 10, the multiple electrode members 20 can be two-dimensionally disposed in the structural body 10. Note that the cavities 1A do not necessarily have to be two-dimensionally disposed in the structural body 10 but rather may be disposed onedimensionally (e.g., linearly). For example, the cavities 1A may be disposed only on a line L shown in FIG. 2A.

Each housing portion 1 is formed to expose the adsorption surfaces 20A1 of electrode members 20. That is, as shown in FIGS. 1B and 2A, the structural body 10 is open at the top (the adsorption surface side of the structural body 10) and is formed to expose the adsorption surfaces 20A1 of the electrode members 20.

1-1-2. Plate-Shaped Portion 2

The structural body 10 includes a plate-shaped portion 2. The plate-shaped portion 2 has a function of insulating adjacent electrode members 20 from each other, as well as a function of transmitting stress applied to the structural body 10 (stress to curve the structural body 10) to the components of the structural body 10.

As shown in FIGS. 3A and 3B, the plate-shaped portion 2 includes multiple first plate-shaped portions 2A, multiple second plate-shaped portions 2B, and multiple third plate-shaped portions 2C. The surfaces of the first to third plate-shaped portions 2A to 2C form the partition walls 1B of the housing portions 1 described above. While, in the present embodiment, the plate-shaped portion 2 (first to third plate-shaped portions 2A to 2C), which is a component of the structural body 10, and a force-acting portion 3 (to be described later) are integrally formed, this is not limiting. The structural body 10 may consist of independent members (separate members) and may be formed by assembling these members.

1-1-2-1. First Plate-Shaped Portion 2A

The multiple first plate-shaped portions 2A are spaced from each other. In the present embodiment, the multiple first plate-shaped portions 2A are arranged in the y-direction. The first plate-shaped portions 2A have wave shapes when the structural body 10 is viewed from above (when the structural body 10 is viewed from a direction similar to that in FIG. 2A). Each first plate-shaped portion 2A is formed by alternately connecting inclined portions 2A1 and protruding portions 2A2. The first plate-shaped portions 2A are disposed to extend in the x-direction and are independently arranged in the y-direction. In other words, the first plate-shaped portions 2A are not directly connected to each other.

Preferably, each inclined portion 2A1 is formed to form a predetermined inclination angle θ with the x-direction, as shown in FIG. 4C. Specifically, for example, the predetermined inclination angle θ may be 15, 20, 25, 30, 35, 40, 45, 50, 55, 60, 65, 70, or 75 degrees and may fall within the range between any two of the values described above as examples. The efficiency of curvature deformation in the y-direction is increased as the inclination angle θ become closer to 45 degrees. For this reason, more preferably, the inclination angle θ is 35 degrees or more and 55 degrees or less. The inclination angle θ may vary among the inclined portions 2A1 or may vary within a single inclined portion 2A1. In these cases, the inclination angle θ only has to be one of the values described above or to fall within the range between any two of the values described above.

Each protruding portion 2A2 is disposed to connect a pair of inclined portions 2A1 and, in one embodiment, is a flat or approximately flat plate. Each protruding portion 2A2 corresponds to a peak (top) or trough (bottom) of a first plate-shaped portion 2A.

While, in the present embodiment, the second plate-shaped portions 2B are flat plates, the second plate-shaped portions 2B may be formed to have wave shapes. Preferably, the first plate-shaped portions 2A and/or the second plate-shaped portions 2B are formed to have wave shapes when the structural body 10 is viewed from above. Modifications 1-4 (to be described later; see FIG. 21) are configurations where both are formed to have shapes.

The width in the Z direction of the first plate-shaped portions 2A is greater than the width in the Z direction of the second plate-shaped portions 2B. In other words, as shown in FIGS. 4B and 4C, the position of the end surface 2B1 of each second plate-shaped portion 2B is lower than the position of the end surface 2A3 of each first plate-shaped portion 2A. Thus, even when the entire electrostatic adsorption device 100 undergoes curvature deformation and thus the distance between the electrode members 20 is reduced, the contact between the electrode members 20 can be avoided.

1-1-2-2. Second Plate-Shaped Portion 2B

Each second plate-shaped portion 2B has a function of transmitting a force (stress to curve the structural body 10) applied to the force-acting portion 3 (to be described later) to an adjacent first plate-shaped portion 2A. Each second plate-shaped portion 2B also has a function of constraining deformation of a first plate-shaped portion 2A. As shown in FIG. 3A, the multiple second plate-shaped portions 2B are spaced from each other. Each second plate-shaped portion 2B is also connected to a pair of adjacent first plate-shaped portions 2A and is disposed to extend in the y-direction.

One end in the y-direction of each second plate-shaped portion 2B is connected to one first plate-shaped portion 2A, and the other end in the y-direction thereof is connected to another first plate-shaped portion 2A. Specifically, one end of each second plate-shaped portion 2B is connected to a protruding portion 2A2 corresponding to a peak of one first plate-shaped portion 2A, and the other end thereof is connected to a protruding portion 2A2 corresponding to a trough of another first plate-shaped portion 2A. The position in which each second plate-shaped portion 2B is connected to a first plate-shaped portion 2A does not have to be an end of the second plate-shaped portion 2B.

The multiple second plate-shaped portions 2B are arranged in the x-direction, as well as in the y-direction. Specifically, as shown in FIG. 3A, the arrangement (positional relationship) of second plate-shaped portions 2B in any column and second plate-shaped portions 2B in a column adjacent in the x-direction to the column is a staggered arrangement. That is, the second plate-shaped portions 2B in the columns adjacent in the x-direction are not arranged in the x-direction but are located in positions shifted in the y-direction.

The first plate-shaped portions 2A and the second plate-shaped portions 2B differ in elasticity. In the present embodiment, the entire plate-shaped portion 2 is made of the same material. For this reason, the different degrees of elasticity of the first plate-shaped portions 2A and the second plate-shaped portions 2B may be achieved by making the thicknesses, lengths, shapes, or the like of the respective plate-shaped portions different. The different degrees of elasticity may be achieved by using different materials. In the present embodiment, the thickness (the width in the y-direction) of each first plate-shaped portion 2A is smaller than the thickness (the width in the x-direction) of each second plate-shaped portion 2B. Moreover, each first plate-shaped portion 2A has a wave shape. For these reasons, the elasticity of each first plate-shaped portion 2A is greater than that of each second plate-shaped portion 2B.

The first plate-shaped portions 2A described above are plate-shaped portions formed in wave shapes and have the higher degree of elasticity due to their shape. In contrast, the second plate-shaped portions 2B are not formed in wave shapes and have the lower degree of elasticity than the first plate-shaped portions 2A. For this reason, the first plate-shaped portions 2A may be referred to as high-elasticity portions, and the second plate-shaped portions 2B as low-elasticity portions. The first plate-shaped portions 2A may also be referred to as high-elasticity rods, and the second plate-shaped portions 2B as low-elasticity rods. If the structural body 10 is an auxetic structural body (to be described later), the first plate-shaped portions 2A may be referred to as chevron-shaped elements.

1-1-2-3. Third Plate-Shaped Portion 2C

The third plate-shaped portions 2C shown in FIG. 3B each have a function of insulating two electrode members 20 arranged in the y-direction from each other. The multiple third plate-shaped portions 2C are arranged in the x-direction, as well as in the y-direction. As shown in FIGS. 4A to 4C, the third plate-shaped portions 2C are connected to the second plate-shaped portions 2B. In the present embodiment, the second plate-shaped portions 2B and the third plate-shaped portions 2C are formed in cross shapes in a plan view. In other words, the second plate-shaped portions 2B and the third plate-shaped portions 2C are connected to each other perpendicularly (connected to form 90-degree angles). Note that the connection angle does not have to be 90 degrees but may be other angles. The width in the z-direction of each third plate-shaped portion 2C is greater than the width in the z-direction of each second plate-shaped portion 2B. In other words, as shown in FIGS. 4B and 4C, the position of the end surface 2B1 of each second plate-shaped portion 2B is lower than the position of the end surface 2C1 of each third plate-shaped portion 2C. Thus, even when the entire electrostatic adsorption device 100 undergoes curvature deformation and thus the distance between the electrode members 20 is reduced, the contact between the electrode members 20 can be avoided.

1-1-3. Force-Acting Portion 3

The structural body 10 also includes the force-acting portion 3. The force-acting portion 3 is configured to be connected to a stress generation mechanism 30 (drive means) for applying stress to deform the structural body 10. The stress generation mechanism need not have a particular configuration but may have various configurations, such as a robot arm. The force-acting portion 3 serves as a handle gripped by the stress generation mechanism, such as a robot arm.

In the present embodiment, the force-acting portion 3 is disposed at edges of the structural body 10. The force-acting portion 3 is connected to first plate-shaped portions 2A. In one embodiment, the force-acting portion 3 is connected to central multiple (two) first plate-shaped portions 2A among the multiple first plate-shaped portions 2A arranged in the y-direction. Stress applied to the force-acting portion 3 is transmitted to the central first plate-shaped portions 2A and is then transmitted to first plate-shaped portions 2A adjacent to the central first plate-shaped portions 2A trough second plate-shaped portions 2B connected to the central first plate-shaped portions 2A. Thus, the stress to curve the structural body 10 is transmitted to the entire structural body 10, thereby deforming (curving) the structural body 10. The stress applied to the force-acting portion 3 is, for example, bending stress that curves the electrostatic adsorption device 100 (structural body 10).

1-1-4. Curved Portion 10a

The structural body 10 is configured to be at least partially deformed to form a curved portion 10a. The curved portion 10a is, for example, a curved portion formed when stress that deforms the structural body 10 is applied to the structural body 10 through the force-acting portion 3, as shown in FIGS. 13A to 13F. While, in one embodiment, the entire structural body 10 is the curved portion 10a, this is not limiting. That is, the structural body 10 may include the curved portion 10a and a non-curved portion (a flat portion) simultaneously when stress is being applied to the structural body 10 through the force-acting portion 3. In other words, the structural body 10 may be configured to include both the curved portion 10a and the flat portion. Such a configuration may be achieved, for example, by changing the material or shape of the structural body 10 by area and, specifically, by forming one portion from a flexible material or shape that is more likely to be curved and forming another portion from a rigid material or shape that is less likely to be curved.

In the present embodiment, the curved portion 10a is curved from one side to the other side in the x-direction, as well as from one side to the other side in the y-direction.

The structural body 10 is configured to form a curve in the x-direction and a curve in the y-direction simultaneously. Specifically, when stress is applied to the force-acting portion 3 of the structural body 10, the structural body 10 simultaneously forms a curve in the x-direction due to the first plate-shaped portions 2A and a curve in the y-direction due to the second plate-shaped portions 2B, forming the curved portion 10a. That is, the structural body 10 is configured to simultaneously form curves in multiple directions (in the present embodiment, two directions: the x-direction and the y-direction).

Specifically, the stress of the force-acting portion 3 is transmitted to the first plate-shaped portions 2A connected to the force-acting portion 3, which are then deformed to be curved from one side to the other side in the x-direction (an example of the first direction). The curve direction at this time may be the +Z direction or the -Z direction. When the curve direction is the +Z direction, the structural body 10 (electrostatic adsorption device 100) can be said to be curved convexly. When the curvature direction is the -Z direction, the structural body 10 (electrostatic adsorption device 100) can be said to be curved concavely.

When a first plate-shaped portion 2A is curved from one side to the other side in the x-direction (an example of the first direction), the wavy first plate-shaped portion 2A is deformed, reducing the distances between the peaks and troughs in the y-direction, as shown in FIGS. 8A and 8B. In other words, the wave shape of the first plate-shaped portion 2A slightly comes close to a flat shape. As a result, a second plate-shaped portion 2B connected to the first plate-shaped portion 2A receives the stress from the first plate-shaped portion 2A and is moved due to the deformation of the first plate-shaped portion 2A. Since the second plate-shaped portion 2B is also connected to another first plate-shaped portion 2A, the stress is transmitted to the other first plate-shaped portion 2A. This process is sequentially repeated, that is, the stress of the force-acting portion 3 is transmitted to all the first plate-shaped portions 2A and second plate-shaped portions 2B arranged in the y-direction. As a result, the structural body 10 is also curved from one side to the other side in the y-direction.

The electrostatic adsorption device 100 is configured such that the structural body 10 can be smoothly curved, that is, can smoothly make a transition from a flat state to a curved state with the interference between the components suppressed. This will be described below. When the first plate-shaped portions 2A are curved from one side to the other side in the x-direction (an example of the first direction), the distances between the opposite protruding portions 2A2 are changed and, correspondingly, the sizes of the cavities 1C are changed, as shown in FIGS. 8A and 8B. In an example in FIGS. 8A and 8B, the structural body 10 is curved concavely. Thus, the distances between the opposite protruding portions 2A2 on the adsorption surface of the electrostatic adsorption device 100 are reduced compared to those before the structural body 10 is curved. That is, the cavities 1C on the adsorption surface of the electrostatic adsorption device 100 are reduced in size. On the other hand, as shown in FIG. 8C, the distances between the opposite protruding portions 2A2 on the surface opposite to the adsorption surface of the electrostatic adsorption device 100 are increased compared to those before the structural body 10 is curved. That is, the cavities 1C on the surface opposite to the adsorption surface of the electrostatic adsorption device 100 are increased in size. The foregoing is the description of the case where the structural body 10 is curved concavely. If the structural body 10 is curved convexly, inverse movements to those described above occur. As seen above, the structural body 10 is configured such that, when making a transition from the flat state to the curved state, the portions on adsorption surface of the cavities 1C and the portions on the surface opposite to the adsorption surface of the cavities 1C have an inverse relationship in size. Thus, the structural body 10 smoothly makes a transition from the flat state to the curved state while avoiding the interference between the components.

The positions of the electrode members 20 when the structural body 10 (electrostatic adsorption device 100) is curved convexly or concavely will be described. As will be described later, each electrode member 20 has an adsorption surface 20A1 for adsorbing an object to be adsorbed. When the structural body 10 is placed in a flat state, the adsorption surfaces 20A1 are disposed parallel to an x-y plane. In contrast, when the structural body 10 is placed in a curved state, the positions of the adsorption surfaces 20A1 move to corresponding positions on a virtual surface Sr shown in FIG. 7. Referring to FIG. 7, the positions of the adsorption surfaces 20A1 in a state in which the curved portion 10a is formed will be described.

In FIG. 7, positions P1 and P2 correspond to the positions of adsorption surfaces 20A1 in a flat state. The positions P1 and P2 are the reference positions of the adsorption surfaces 20A1, such as the positions of the center of gravity, and can be determined using any method. The position P1 is the position of an adsorption surface 20A1 close to the periphery of the structural body 10, and the position P2 is the position of an adsorption surface 20A1 close to the center of the structural body 10.

In FIG. 7, positions T1 and T2 correspond to the positions of the adsorption surfaces 20A1 in a curved state. The positions T1 and T2 are located on the virtual surface Sr. In the present embodiment, the virtual surface Sr corresponds to a part of the surface of a sphere with any radius. In other words, the virtual surface Sr has a dome shape. While the movement of the positions of the two adsorption surfaces 20A1 has been described above, other adsorption surfaces 20A1 are also located on the virtual surface Sr in the curved state.

Examples of the virtual surface Sr include a double-curved surface and a single-curved surface. The double-curved surface is, for example, a spherical surface, an ellipsoidal surface, or the like. The single-curved surface is, for example, a cylindrical surface or the like. Note that the virtual surface Sr of the structural body 10 does not have to be a spherical, ellipsoidal, or cylindrical surface but may be any other complex curved surface. In other words, while, in the present embodiment, the virtual surface Sr is a sphere (a part of the surface of a sphere), this is not limiting. If the curve of the structural body 10 is complex, the virtual surface Sr becomes a corresponding complex curved surface.

As seen above, the adsorption surfaces 20A1 of the multiple electrode members 20 are located in the corresponding positions along the curved portion 10a (the positions T1 and T2 on the virtual surface Sr in one embodiment) in the curved state, in which the curved portion 10a is formed in the structural body 10. Thus, the electrostatic adsorption device 100 is able to adjust the curve of the structural body 10 in accordance with the curve of the object to be adsorbed and to locate the adsorption surfaces 20A1 in positions along the curved surface of the object. In other words, the electrostatic adsorption device 100 is able to locate the adsorption surfaces 20A1 of the electrode members 20 in the positions along the curved surface of the object corresponding to the curve of the curved portion 10a, that is, has enhanced curved surface adaptation capability. As used herein, the term "curved surface adaptation capability" refers to capability indicating whether the electrostatic adsorption device 100 is able to easily move the adsorption surfaces 20A1 to the positions along the curved surface of the object.

An example of the structural body 10 configured to simultaneously form a curve in the x-direction and a curve in the y-direction is an auxetic structural body (expanded auxetic structural body). For this reason, the structural body 10 may consist of an auxetic structural body (expanded auxetic structural body). An auxetic structural body (expanded auxetic structural body) will be described in detail in "2. Auxetic Structural Body (Expanded Auxetic Structural Body)" later.

1-2. Electrode Member 20

As shown in FIGS. 1A and 1B, the electrode members 20 are configured to be inserted into the structural body 10. When the electrode members 20 are inserted into the structural body 10, the electrode members 20 are engaged with and held in the structural body 10.

The electrode members 20 are disposed to be at least partially covered by the structural body 10. In other words, the electrode members 20 are disposed to be at least partially surrounded by the structural body 10. That is, the positions in the z-direction of the electrode members 20 match that of the structural body 10. In other words, the electrode members 20 are not disposed to protrude from the structural body 10 in the z-direction but are disposed in the same or substantially the same positions as that of the structural body 10 in the z-direction. This can suppress upsizing of the electrostatic adsorption device 100. The portions covered (surrounded) by the structural body 10 of the electrode members 20 may be in contact with or in no contact with the structural body 10.

In response to the curved portion 10a being formed in the structural body 10 (in response to the structural body 10 being placed in a curved state), the electrode members 20 moves and their adsorption surfaces 20A1 are located in corresponding positions along the curved portion 10a. As a result, the electrostatic adsorption device 100 is able to locate the adsorption surfaces 20A1 of the electrode members 20 in positions along the curved surface of the object to be adsorbed corresponding to the curve of the curved portion 10a. In other words, the electrostatic adsorption device 100 is able to easily match the curvature or radius of the curve of the structural body 10 itself with the curvature or radius of the virtual surface Sr and to easily locate the adsorption surfaces 20A1 in the positions along the curved surface of the object to be adsorbed. That is, the electrostatic adsorption device 100 according to the present embodiment has improved capability to adapt to the curved surface of the object.

As shown in FIGS. 6A to 6D, an electrode member 20 includes a base portion 20A and inserted portions 20B. As shown in FIG. 5B, the base portion 20A of each electrode member 20 is disposed on a second plate-shaped portion 2B with the electrode member 20 inserted into the structural body 10. The base portion 20A has an adsorption surface 20A1 for electrostatically adsorbing the object to be adsorbed. While, in the present embodiment, the adsorption surface 20A1 consists of a flat surface, this is not limiting. It may consist of a curved surface, a surface with multiple protrusions and depressions, or a surface including both flat and curved surfaces. Both the base portion 20A and the inserted portions 20B are contained in a housing portion 1. In the present embodiment, the electrode members 20 are held in the housing portions 1 by the friction between them and the surface of the structural body 10. Each electrode member 20 includes multiple (two in the present embodiment) inserted portions 20B. This increases the surface area of the electrode member 20, making it easy to hold the electrode member 20 in the housing portion 1. The inserted portions 20B are inserted into a roughly triangular space formed by a first plate-shaped portion 2A, a second plate-shaped portion 2B, and a third plate-shaped portion 2C. A cavity 20C is formed between the pair of inserted portions 20B. The second plate-shaped portion 2B is disposed in the cavity 20C with the electrode member 20 contained in the housing portion 1.

In the present embodiment, each rhombic cavities 1A of the structural body 10 is divided by a third plate-shaped portion 2C. A pair of electrode members 20 are disposed in the spaces of the divided cavity 1A so as to be symmetrical with respect to the third plate-shaped portion 2C. Positive and negative voltages are applied to the pair of electrode members 20, respectively, by a voltage application device 50 (see FIG. 16B) including a power supply. Thus, the electrostatic adsorption device 100 is able to adsorb the object to be adsorbed. A single electrode member 20 may be mounted on each rhombic cavity 1A of the structural body 10, and positive and negative voltages may be applied to adjacent electrode members 20. The number of electrode members 20 mounted on each rhombic cavity 1A of the structural body 10 may be more than two.

The adsorption surfaces 20A1 of the electrode members 20 are preferably bipolar. Each electrode member 20 preferably consists of a positive electrode, a negative electrode, and an insulating area between them. The insulating area is a component for insulating the positive and negative electrodes of the electrode member 20 from each other. If the adsorption surfaces 20A1 are bipolar, there is no need to connect or dispose an electrode to or on the object to be adsorbed. Thus, the object can be transported with one surface thereof adsorbed.

To make an adsorption surface 20A1 bipolar, it is preferable to dispose a positive electrode and a negative electrode on the adsorption surface 20A1 in a uniformly distributed manner. A single electrode member 20 may include both a positive electrode and a negative electrode.

Examples of the material of the electrode members 20 include metals such as stainless steel or aluminum, semiconductors such as a doped Si wafer, and the like. Examples of the material (insulating material) of the insulating areas of the electrode members 20 include polyamide, polyimide, acrylate, and the like. The electrode members 20 may be produced using any known technology, such as 3D printing or water jet cutting.

In the electrostatic adsorption device 100, at least one of the adsorption surface of each electrode member 20 20A1 and the surface opposite thereto may be covered with an insulator (insulating layer). If an insulating layer is disposed on the adsorption surface 20A1 of each electrode member 20 and the insulating layer is elastically deformable, or soft, the insulating layer on the adsorption surface 20A1 helps adaptation to the surface shape, such as the curved surface, of the object to be adsorbed due to its flexibility. The insulating layer also helps avoid a fall of the electrode member 20 inserted into the structural body 10.

The dimensions in the x- and y-directions of the adsorption surface 20A1 of each electrode member 20 may be various dimensions, such as 10 μm to 10 cm, 10 μm to 1000 μm, 1 to 10 mm, 1 to 10 cm, and 10 cm or more. The dimensions in the x- and y-directions may differ.

As shown in FIGS. 6A and 6D, the electrode member 20 has a top portion 20a. The top portion 20a is not sharply pointed unlike a vertex of a triangle but has, for example, a flat surface. This makes the electrode member 20 less likely to interfere with deformation of a first plate-shaped portion 2A.

2. Auxetic Structural Body

2-1. Poisson's Ratio of Structural Body 10

A structural body called an auxetic structural body is known. While the structural body 10 according to the present embodiment does not necessarily have to be an auxetic structural body, it is preferable to use an auxetic structural body in order to adsorb a curved wafer or film. An auxetic structural body as an example configuration of the structural body 10 will be described below in detail.

In one embodiment described below, the tensile direction is the above-mentioned x-direction. Moreover, the term "Poisson's ratio" is used. Poisson's ratio here corresponds to the ratio between the amount of deformation in the longitudinal direction (the tensile direction) of any material and the amount of deformation in the transverse direction (a direction perpendicular to the tensile direction) thereof when a load is applied to the material.

If the structural body 10 is an auxetic structural body, the structural body 10 is defined as a structural body having a negative or zero Poisson's ratio whose dimension in the direction perpendicular to the tensile direction is extended or remains constant. The electrode members 20 are supported by the structural body 10 having such a Poisson's ratio.

It should be noted that in the present embodiment, Poisson's ratio is applied to the electrostatic adsorption device 100 (structural body 10) in an extended manner. Specifically, the Poisson's ratio of the electrostatic adsorption device 100 (structural body 10) can be defined as the ratio between the amount of change in the width in the x-direction of the electrostatic adsorption device 100 (structural body 10) and the amount of change in the width in the y-direction of the electrostatic adsorption device 100 (structural body 10). More specifically, in the present embodiment, the Poisson's ratio of the auxetic structural body (structural body 10) is applied to deformation based on the geometric pattern (array) of the structural body 10, rather than deformation based on the material composition of structural body 10. The auxetic structural body can be understood as a structural body including skeletal portions forming a geometric pattern (array) and patterned spaces formed between the skeletal portions. The skeletal portions include portions that are bent (deformed), such as hinges. The auxetic structural body has a characteristic in which it is deformed into a dome shape when undergoing bending stress.

While auxetic structural bodies typically have a negative Poisson's ratio, examples of the auxetic structural body according to the present embodiment include that having a zero Poisson's ratio. For this reason, the auxetic structural body according to the present embodiment may be defined as an extended auxetic structural body so that an auxetic structural body having a zero Poisson's ratio is included.

2-2. Poisson's Ratio

Referring to FIGS. 9A to 9C, the relationship between Poisson's ratio and deformation due to tensile stress will be briefly described. In FIGS. 9A to 9C, a shape that has yet to undergo tensile stress is represented by solid lines, while a shape that has undergone tensile stress is represented by dashed lines. For a typical material or structure having a positive Poisson's ratio shown in FIG. 9A, compared to a shape 1-1 that has yet to undergo tensile stress, a shape 1-2 that has undergone tensile stress is compressed in directions perpendicular to the tensile direction. For a material or structure having a negative Poisson's ratio shown in FIG. 9B, compared to a shape 2-1 that has yet to undergo tensile stress, a shape 2-2 that has undergone the tensile stress is extended in directions perpendicular to the tensile direction. For a material or structure having a zero Poisson's ratio shown in FIG. 9C, compared to a shape 3-1 that has yet to undergo tensile stress, a shape 3-2 that has undergone tensile stress remains unchanged in directions perpendicular to the tensile direction. While, in FIGS. 9B and 9C, the dimension is extended or remains unchanged in both the two directions perpendicular to the tensile direction, the dimension may be extended or remain unchanged only in one direction perpendicular to the tensile direction.

2-3. Chevron-Shaped Element (First Plate-Shaped Portion 2A)

As shown in FIGS. 10A and 10B, the wavy first plate-shaped portions 2A described above correspond to the chevron-shaped elements of an auxetic structural body. The multiple chevron-shaped elements have the x-direction as their longitudinal direction and are disposed in parallel in the x-direction. The electrode members 20 are inserted between the adjacent chevron-shaped elements. As shown in FIGS. 10C and 10D, the chevron-shaped elements are deformed by tensile stress (load) in the x-direction such that the height of the chevron shape is reduced (deformed such that the width in the y-direction is reduced), extending in the x-direction. Thus, the bent angle of the chevron-shaped elements is expanded from approximately 90° to become an obtuse angle. At this time, the entire electrostatic adsorption device 100 (structural body 10) is also expanded in the y-direction, that is, in a direction perpendicular to the tensile direction.

FIG. 10E shows the state of the structural body 10 of the electrostatic adsorption device 100 in which the adsorption surface side is concavely curved due to application of bending stress to bend the structural body 10. As shown in FIG. 10E, it is preferable to apply the bending stress such that the internal dimension of the peripheral edge fr (see also FIG. 1B) of the adsorption surface side of the structural body 10 remains constant. The internal dimension corresponds to the internal dimension of a curve along the virtual surface Sr of the curved portion 10a, or the internal dimension of the peripheral edge fr shown in FIG. 10E. When such bending stress is applied, the dimension of the concave surface (double-curved surface) inside the peripheral edge fr of the adsorption surface side remains constant or is reduced. Here, the concave surface (double-curved surface) corresponds to the above virtual surface Sr. However, even when the dimension is reduced, the reduced dimension is very small. This is because, when the structural body 10 is concavely curved, the adsorption surface side portions of the first plate-shaped portions 2A serving as chevron-shaped elements attempts to contract but are less likely to contract due to interference of the first plate-shaped portions 2A with the electrode members 20. This is also because the contraction of the first plate-shaped portions 2A is also suppressed by the second plate-shaped portions 2B as low-elasticity portions. Since the dimension of the concave curved surface remains constant or its reduction is suppressed, the area of the concave curved surface also remains constant or its reduction is suppressed. Thus, formation of wrinkles on the object to be adsorbed can be suppressed. That the adsorption surface side portions of the structural body 10 are less likely to contract corresponds to that the neutral surface (the surface that does not expand or contract) of the structural body 10 shifts toward the adsorption surface side when the structural body 10 is curved.

The foregoing is the description of the example where the structural body 10 is concavely curved (deformed). In contrast, when the structural body 10 is convexly curved, the rhombic flat virtual surface Sr of the structural body 10 is deformed into a convex curved surface (e.g., see the virtual surface Sr in FIG. 7). The area of the convex curved surface is increased compared to that of the rhombic flat virtual surface Sr that has yet to be deformed. The increase in the area of the convex curved surface allows the object to be electrostatically adsorbed (e.g., a film) to be more reliably adsorbed. In other words, when the electrostatic adsorption device 100 in a flat state adsorbs the object and then makes a transition to a curved state, the area is expanded in the transition from the flat state to the curved state and thus stress acts such that the surface of the object is stretched. This is advantageous in that formation of wrinkles on the object can be suppressed. Note that while the advantage obtained by keeping constant or increasing the area has been described above, an embodiment that contracts the area is not excluded.

The structural body 10 includes the more elastic first plate-shaped portions 2A and less elastic second plate-shaped portions 2B. If the structural body 10 is an auxetic structural body, the structural body including the first plate-shaped portions 2A and the second plate-shaped portions 2B can be defined as a re-entrant honeycomb structure.

By changing the inclination angle θ of the inclined portions 2A1, which are the inclined portions of the chevron-shaped elements, the magnitude of extension and curve in the y-direction when the tensile (extension) stress in the x-direction is transmitted to the y-direction can be adjusted. When the inclination angle θ is reduced, the magnitude of extension in the y-direction with respect to the tensile (extension) stress in the x-direction can be increased. Therefore, by changing the inclination angle θ, the shape of the double-curved surface can be changed. Changing the interval between the chevron-shaped elements, that is, the length of the second plate-shaped portions 2B can also change the shape of the virtual surface Sr.

2-4. Properties of Auxetic Structural Body according to Embodiment

2-4-1. Deformation Due to Application of Tensile Stress in X-Direction

FIGS. 11A to 11C show changes in the shape of the structural body 10 when tensile stress in the x-direction (without bending stress) is applied to the structural body 10. The structural body 10 serving as an auxetic structural body is configured to, when tensile stress in the x-direction is applied thereto, increase in the width in the y-direction. This will be described below. The first plate-shaped portions 2A may be referred to as the chevron-shaped elements.

When tensile stress in the x-direction is applied to the two chevron-shaped elements (first plate-shaped portions 2A), which are elastic elements connected to the force-acting portion 3, the chevron-shaped elements are deformed to extend in the x-direction. This x-direction extension of the chevron-shaped elements is elastic deformation in which their height is reduced. In other words, this extension is a shape change in which the peaks and troughs of the chevron-shaped elements act as hinges and angles formed by the peaks and troughs are increased. Substantially, this extension is not elastic extension of the material itself of the chevron-shaped elements. The extension of the chevron-shaped elements at the center in the y-direction is transmitted through second plate-shaped portions 2B to adjacent chevron-shaped elements, which then extend in the x-direction as well.

Hereafter, as shown in FIG. 3A, the two chevron-shaped elements (first plate-shaped portions 2A) connected to the force-acting portion 3 will be referred to as first high-elasticity rods R1, and subsequent high-elasticity rods sequentially as second high-elasticity rods R2, third high-elasticity rods R3, fourth high-elasticity rods R4, and fifth high-elasticity rods R5. Moreover, as shown in FIG. 3A, the low-elasticity rods (second plate-shaped portions 2B) connected to the inside of the high-elasticity rods will be referred to as first to fifth low-elasticity rods r1 to r5, respectively.

When tensile stress is applied to the two upper and lower first high-elasticity rods R1 by the force-acting portion 3, both the wavy first high-elasticity rods R1 are deformed and extend to decrease in height (reduce the difference in height between the peaks and troughs). When the two upper and lower first high-elasticity rods R 1 extend, the tensile stress in the x-direction is also transmitted through the upper and lower second low-elasticity rods r2 (rods relatively resistant to dimensional change) to the upper and lower second high-elasticity rods R2, which then extend as well. Similarly, the tensile stress in the x-direction is transmitted to all the third to fifth high-elasticity rods R3 to R5.

When the tensile stress is applied to the upper and lower two first high-elasticity rods R1, the wavy first high-elasticity rods are deformed to decrease in height. The first low-elasticity rods r1 (with a constant dimension) are interposed between the peaks of one first high-elasticity rod R1 and the troughs of the other first high-elasticity rod R1. On the other hand, nothing is interposed between the troughs of the one first high-elasticity rod R1 and the peaks of the other first high-elasticity rod R1 (i.e., the cavities 1C are formed). For this reason, both the one and other first high-elasticity rods R1 are deformed such that the interval (distance) between the troughs of the one first high-elasticity rod R1 and the peaks of the other first high-elasticity rod R1 is increased. Specifically, the troughs of the one first high-elasticity rod R1 move upward, and the peaks of the other first high-elasticity rod R1 move downward.

When the troughs of the one first high-elasticity rod R1 move upward, one second low-elasticity rod r2 also moves upward. When the one second low-elasticity rod r2 moves upward, one second high-elasticity rod R2 (specifically, their peaks) also move upward. At this time, as described above, the wavy one second high-elasticity rod R2 also extends and is deformed to decrease in height. Thus, the troughs of the one second high-elasticity rod R2 move upward with respect to the positions in the y-direction of the peaks of the one second high-elasticity rod R2. The movements of another second low-elasticity rod r2 and another second high-elasticity rod R2 are symmetrical with respect to those of the above-mentioned one second low-elasticity rod r2 and the one second high-elasticity rod R2 and therefore will not be described. Such movements are sequentially transmitted to the third to fifth low-elasticity rods r3 to r5 and the third to fifth high-elasticity rods R3 to R5. As seen above, when the first high-elasticity rods R1 are extended in the x-direction by undergoing the tensile stress, the auxetic structural body increases in dimension in the y-direction (both the $\pm$y-directions) perpendicular to the tensile direction. The degree of extension of the fifth high-elasticity rods R5 located at the vertexes of the rhombus is smallest. In other words, the extension of the elastic rods decreases stepwise (regularly) from the first high-elasticity rods R1 toward the vertexes of the rhombus. The degree of increase in the interval (distance) between the adjacent elastic rods also gradually decreases from the first high-elasticity rods R1 toward the vertexes of the rhombus.

The auxetic structural body (structural body 10) described here has a negative Poisson's ratio. The thickness (the dimension in the z-direction) of the structural body 10 substantially remains unchanged. That is, in the above description, it is assumed that the structural body 10 is a two-dimensional auxetic structural body. However, if the structural body 10 is a three-dimensional auxetic structural body, it may change in dimension in the three-dimensional directions.

2-4-2. Deformation Due to Application of Bending Stress

FIGS. 12A to 12F show changes in shape when bending stress (which is not the tensile stress described with reference to FIGS. 11A to 11C) is applied to the structural body 10. When bending stress is applied to the structural body 10 serving as an auxetic structural body, the structural body 10 is curved such that the diagonal in the x-direction of the rhombus becomes convex upward. Simultaneously, the structural body 10 is also curved in a direction (Y-direction) perpendicular to the x-direction in an xy plane, generating a double-curved surface. This double-curved surface corresponds to the virtual surface Sr representing the after-movement positions of the adsorption surfaces 20A1 of the electrode members 20 disposed on the structural body 10.

The reason why the double-curved surface (curved surface) is generated is as follows. The stress generation mechanism 30 generates an upward (+Z direction) convex curve in the structural body 10. At this time, the circumferential dimension of the upper surface (convex surface) in the Z direction of the structural body 10 is increased compared to the circumferential dimension of the lower surface (concave surface) in the Z direction. The upper surface (convex surface) corresponds to a surface Rg1 shown in FIG. 2C, and the lower surface (concave surface) corresponds to a surface Rg2 in the same drawing. Here, a case is considered where tensile stress acts on both the upper surface (convex surface) and the lower surface (concave surface) of the structural body 10 due to bending stress applied to the structural body 10. When the structural body 10 has a negative Poisson's ratio, the effect of the extension in the x-direction on the extension in the y-direction is greater on the upper surface (convex surface) than on the lower surface (concave surface). In other words, the extension of the upper surface (convex surface) of the structural body 10 is greater, while the extension of the lower surface (concave surface) is smaller. As seen above, there is a difference in the y-direction extension between the upper surface (convex surface) and the lower surface (concave surface). For this reason, bending stress in the y-direction occurs. That is, the structural body 10 is curved from one side to the other side in the y-direction.

While the case in which both the upper surface (convex surface) and the lower surface (concave surface) extend has been described above, this is not limiting. Even when the dimension of the lower surface (concave surface) is constant, or even when the dimension of the lower surface (concave surface) is reduced and compressive stress occurs, bending stress in the y-direction occurs, resulting in formation of a double-curved surface.

2-4-3. Deformation of Structural body 10 in which Electrode Members 20 Are Inserted

FIGS. 13A to 13C and FIGS. 14A to 14F show the process of deformation of the auxetic structural body (structural body 10) in which the electrode members 20 are inserted. From these drawings, it can be understood that the deformation of the auxetic structural body in which the electrode members 20 are inserted is similar to the description in Sections 2-4-1 and 2-4-2.

2-4-4. Functions of Auxetic Structural Body

As described above, when the stress generation mechanism 30 applies bending stress to the electrostatic adsorption device 100 (structural body 10), a curve in the x-direction (an example of the first direction) and a curve in the y-direction (an example of the second direction) are simultaneously formed in the electrostatic adsorption device 100 (structural body 10), forming a double-curved surface. In other words, the structural body 10 is configured to form a curve in the x-direction and a curve in the y-direction simultaneously. These curves formed in the multiple directions are based on the following functions 1 and 2.

Function 1

When the structural body 10 is pulled in a specific direction (x-direction), the structural body 10 increases not only in the width in the specific direction but also in the width in a direction intersecting the specific direction (y-direction). The function 1 is the function described in Section 2-4-1 above. The function 1 is effectively achieved by disposing the second plate-shaped portions 2B in the areas in which the opposing width between the adjacent wavy first plate-shaped portions 2A are greatest (the areas between the troughs and peaks). Note that the second plate-shaped portions 2B do not have to completely match the areas in which the opposing width is greatest but may be slightly shifted therefrom. The function 1 is also effectively achieved by making the elasticity of the second plate-shaped portions 2B lower than that of the first plate-shaped portions 2A. This is because the second plate-shaped portions 2B having the lower elasticity facilitates the transmission of deformation of any first plate-shaped portion 2A to a first plate-shaped portion 2A adjacent to the first plate-shaped portion 2A, thereby facilitating securement of the amount of deformation in the y-direction of the structural body 10.

Function 2

When bending stress is applied to the structural body 10 such that the structural body 10 forms a convex shape in the +Z direction, the dimension of the upper surface (corresponding to the region Rg1 in FIG. 2C) in the Z direction and the dimension of the lower surface (corresponding to the region Rg2 in FIG. 2C) in the Z direction are changed by different amounts. In the present embodiment, the dimension of the upper surface is changed by a greater amount than the dimension of the lower surface. If the structural body 10 is an auxetic structural body, the amount of change in dimension in the y-direction is changed in accordance with the amount of change in dimension in the tensile direction. Since the amount of change in dimension in the tensile direction is greater, the amount of change in dimension in the y-direction becomes greater. On the other hand, since the amount of change in dimension of the lower surface in the tensile direction is smaller, the amount of change in dimension in the y-direction becomes smaller. As seen above, the dimensions are changed by different amounts also in the y-direction, resulting in formation of a curve in the y-direction.

While the structural body 10 is configured to form a curve in the x-direction and a curve in the y-direction simultaneously using the functions 1 and 2, it does not necessarily have to use the function 1 or 2 but may use other functions.

2-5. Electrostatic Adsorption

FIG. 15 shows a state in which the wiring of the voltage application device 50 is applied to the electrode members 20 of the electrostatic adsorption device 100 including the auxetic structural body. FIG. 15 also shows a state in which the flat electrostatic adsorption device 100 is electrostatically adsorbing a plastic film and a subsequent state in which the electrostatic adsorption device 100 is curved, forming a double-curved surface with R100 (mm).

Referring to FIGS. 16A and 16B, there will be described a calculation formula used to deform the adsorption surface of the electrostatic adsorption device 100 shown in FIG. 15 from the flat surface to the double-curved surface while keeping constant the length of each side of the rhombus of the adsorption surface. Note that the adsorption surface described in this Section 2-5 corresponds to the virtual surface Sr and does not refer to the adsorption surface 20A1 of a single electrode member 20.

In FIG. 16A, h represents the transverse (x-direction) length of the rhombic adsorption surface, w represents the longitudinal (y-direction) length, and R represents the curvature radius to be formed. A point a represents the upper corner of the rhombus, and a point b represents the right corner of the rhombus.

FIG. 16B is a side view of the electrostatic adsorption device 100 when the adsorption surface is curved with the curvature radius R. The lower corner of the longitudinal (y-direction) diagonal of the rhombus of the adsorption surface in FIG. 16A is located at the center in the x-direction of the adsorption surface in the side view of FIG. 16B. The location of this corner is defined as the origin of x-z coordinate axes where the x-axis represents the transverse direction and the z-axis represents the longitudinal direction, and the coordinates of the origin are expressed as (0, 0). In this case, the coordinates of points at both ends of the transverse (x-direction) diagonal of the rhombus can be expressed as (x, 0) and (-x, 0), respectively, in FIG. 16B. The inclination angle of the adsorption surface at the point b when the adsorption surface is curved with the curvature radius R is expressed as $\theta$.

First, $z_2$ is obtained from h, w, and R using the following formula.

[Formula 1]

$$\frac{h}{w} = \frac{\cos^{-1}\frac{z_2}{R}}{\cos^{-1}\frac{z_1}{R}}$$

$$\cos^{-1}\frac{z_1 z_2}{R^2} = \frac{\sqrt{w^2 + h^2}}{2R}$$

From $z_2$ obtained, x and $\theta$ can be determined using the following formula.

[Formula 2]

$$x = \sqrt{R^2 + z_2{}^2}$$

$$\theta = \cos^{-1}\frac{z_2{}^2 - x^2}{R^2}$$

The obtained x represents the X-direction positions to which the points at both ends of the X-direction diagonal of the rhombic adsorption surface should be moved by the force-acting portion 3 of the electrostatic adsorption device 100 in order to curve the adsorption surface to the curvature radius R. The obtained $\theta$ represents the inclination angle of the bending at these X-direction positions.

When actually operating the electrostatic adsorption device 100, it is preferable to calculate x and $\theta$ so that the curvature radius R is gradually changed from infinity to the target curvature radius and then to drive the electrostatic adsorption device 100 along the values of x and $\theta$ obtained. The electrostatic adsorption device 100 can be driven, for example, using a computer and a robot arm.

In FIG. 15, reflection (haze) is seen on the film due to light reflection. When the adsorption surface is flat, the film is adsorbed by the adsorption surface without wrinkles. On the other hand, when the adsorption surface is a double-curved surface, wrinkles are seen on a part of the adsorption surface, but are found to be minimal.

3. Various Methods Using Electrostatic Adsorption Device 100

3-1. Wafer Warp Correction Method

Wafers have been enlarged and thinned down in recent years. Consequently, for example, wafers may become warped (become curved) during their transportation or the like. The electrostatic adsorption device 100 is able to adsorb such a warped wafer while effectively avoiding damage or the like thereto and thus to transport the wafer without damage or the like. The electrostatic adsorption device 100 is also able to correct a warped wafer so that the wafer is flattened. The electrostatic adsorption device 100 can be applied to any type of wafers. For example, it is suitable for wafers for power semiconductors.

A wafer warp correction method according to the present embodiment includes an adsorption step and a warp correction step. The adsorption step includes causing the adsorption surfaces 20A1 of the electrode members 20 of the structural body 10 in a curved state to adsorb a wafer. The warp correction step includes causing the structural body 10 to make a transition from the curved state to a flat state with the adsorption surfaces 20A1 adsorbing the object to be adsorbed.

The above curved state is, for example, a state in which the structural body 10 is curved, as shown in FIG. 8A and the like. The structural body 10 may be curved convexly or concavely, or may be curved such that convex and concave portions are combined.

In the above flat state, the adsorption surfaces 20A1 of the multiple electrode members 20 are aligned in height, for example, as shown in FIG. 1B.

By pressing the electrostatic adsorption device 100 against a wafer, which is an object to be adsorbed, the electrostatic adsorption device 100 may be additionally deformed such that its shape conforms to or approximates the surface shape of the wafer. In other words, the adsorption process may include causing the adsorption surfaces 20A1 of the electrode member 20 to adsorb the object to be adsorbed while causing the structural body 10 to make a transition to a curved state.

The warp correction method may be performed with the wafer adsorbed in the adsorption step placed on a placement stage. The warp correction method may include sucking the wafer under reduced pressure trough a suction hole formed in the placement stage so that the wafer is prevented from being misaligned from the placement stage.

Preferably, the difference in height between the uppermost adsorption surface and the lowermost adsorption surface is 10 cm or less. The uppermost adsorption surface is an adsorption surface 20A1 in the highest position in the z-direction among the adsorption surfaces 20A1 on the curved portion 10a. The lowermost adsorption surface is an adsorption surface 20A1 in the lowest position in the z-direction among the adsorption surfaces 20A1 on the curved portion 10a.

3-2. Film Mounting Method

The screen of a display such as an organic EL can be curved. However, in the case of a large display, it is difficult to grasp a flat sheet member (e.g., a thin-film electronic device) for use with the display and uniformly mount it on the curved surface of the display structure.

The electrostatic adsorption device 100 is able to uniformly mount a film (sheet member) on the curved surface of a display structure while effectively avoiding damage or the like to the film.

A film mounting method according to the present embodiment includes an adsorption step, a deformation step, and a mounting step. The adsorption step includes causing the adsorption surfaces 20A1 of the electrode members 20 of the structural body 10 to adsorb a film. The deformation step includes placing the structural body 10 in a curved state. The deformation step is a step performed before, after, or concurrently with the adsorption step. The mounting step includes mounting the film adsorbed by the structural body 10 in the curved state on a destination object. The destination object is, for example, a structural body constituting a display, such as an organic EL display. The mounting step includes controlling the voltage of the voltage application device 50 so that the film is detached (released) from the adsorption surface of the electrostatic adsorption device 100.

The area of the virtual surface Sr consisting of the adsorption surfaces 20A1 in the curved state is increased compared to the area of the adsorption surfaces 20A1 in the flat state or remains constant, or, if reduced, the amount of reduction is small. Thus, formation of wrinkles on the film can be effectively suppressed. If the adsorption-related area significantly is reduced, the possibility that wrinkles will be formed on the film is increased. In the case of the electrostatic adsorption device 100 according to the present embodiment, when it makes a transition from a flat state to a curved state, the area of the virtual surface Sr is increased or remains constant, or, if reduced, the amount of reduction is small. Thus, formation of wrinkles on the film is more likely to be avoided.

4. Advantageous Effects of Embodiment

In the electrostatic adsorption device 100 according to the present embodiment, the electrode members 20 are disposed to be at least partially covered by the structural body 10 that can form the curved portion 10a. That is, the electrode members 20 are integrally disposed on the structural body 10. Thus, in response to the curved portion 10a being formed in the structural body 10, the electrode members 20 move and their adsorption surfaces 20A1 are located in the corresponding positions along the curved portion 10a (see FIG. 7). As a result, the electrostatic adsorption device 100 is able to locate the adsorption surfaces 20A1 of the electrode members 20 in the positions along the curved surface of the object to be adsorbed corresponding to the curve of the curved portion 10a, that is, has enhanced curved surface adaptation capability.

In the electrostatic adsorption device 100 according to the present embodiment, the electrode members 20 are integrally disposed on the structural body 10. Thus, the electrostatic adsorption device 100 can be downsized and thinned down accordingly.

5. Modifications

5-1. Modification 1: Modification of Structural Body 10

5-1-1. Modification 1-1: Negative Poisson's Ratio

In a modification 1-1 shown in FIGS. 17A and 17B, a structural body 10 consists of an auxetic structural body having a negative Poisson's ratio. While, in the above embodiment shown in FIG. 4C, the first plate-shaped portions 2A include the protruding portions 2A2 formed in a flat shape, in the modification 1-1, these portions are formed to have acute angles. Such a configuration can also obtain the same advantageous effects as the above embodiment. Note that an angle θ shown is greater than 0 degrees and smaller than 90 degrees. As shown in FIGS. 18A and 18B, when tensile stress is applied to the structural body 10, the structural body 10 increases not only in the width in the tensile direction but also in the width in a direction perpendicular to the tensile direction.

5-1-2. Modification 1-2: Poisson's Ratio of Zero

In a modification 1-2 shown in FIGS. 17C, 17D, and 19A to 19C, a structural body 10 consists of an auxetic structural body having a zero Poisson's ratio (extended auxetic structural body).

In this structural body, first plate-shaped portions 2A are disposed in parallel in the y-direction such that the positions of the peaks and troughs of each first plate-shaped portion 2A coincide with those of the peaks and troughs of the other first plate-shaped portions 2A in the x-direction. The modification 1-2 differs in this point from the above embodiment and modification 1-1. The angles at which second plate-shaped portions 2B and the first plate-shaped portions 2A intersect each other are an acute angle θ ($0°<θ<90°$) and the complementary angle of θ ($180°-θ$). The angle θ is preferably $30°≤θ≤80°$, more preferably $30°≤θ≤60°$.

When tensile stress in the x-direction is applied to the structural body 10, each first plate-shaped portion 2A is extended in the x-direction and is deformed such that the troughs thereof are lifted. However, the structural body 10 is not increased in the width in the y-direction since an adjacent first plate-shaped portion 2A moves such that the troughs thereof are lifted as well. In other words, as shown in FIGS. 18C and 18D, when tensile stress is applied to the structural body 10, the structural body 10 is increased only in the width in the tensile direction and is the same in the width in a direction perpendicular to the tensile direction. While, in the above embodiment and modification 1-1, the virtual surface Sr is formed as a double-curved surface (e.g., a sphere, etc.), in the modification 1-2, the virtual surface Sr is formed as a single-curved surface (e.g., a cylindrical surface, etc.). In other words, in the modification 1-2, the structural body 10 is configured to form a curve only in the specific direction (x-direction).

FIG. 20 shows a change in shape when bending stress is applied to the structural body 10 according to the modification 1-2. As shown in FIG. 20, it can be seen that the dimension in the y-direction remains unchanged (constant). That is, it can be seen that the virtual surface Sr becomes a single-curved surface.

### 5-1-3. Modification 1-3: Positive Poisson's Ratio

In a modification 1-3 shown in FIGS. 17E and 17F, a structural body 10 has a positive Poisson's ratio. This structural body 10 has a honeycomb structure. The angle $\theta$ at which first plate-shaped portions 2A arranged in the y-direction and second plate-shaped portions 2B arranged in the x-direction are connected to each other satisfies $90° < \theta < 180°$. When tensile stress is applied in the length direction (x-direction) of the first plate-shaped portions 2A, this structural body is deformed such that the distance between the first plate-shaped portions 2A is reduced. The structural body 10 may adopt a configuration such as the modification 1-3.

### 5-1-4. Modification 1-4: Auxetic Structural Body without Re-entrant Honeycomb Structure

FIG. 21 shows an example of a structural body having a sinusoidal lattice pattern, as another example of an auxetic structural body. This structural body 10 does not have a re-entrant honeycomb structure. Moreover, this structural body 10 does not include second plate-shaped portions 2B. That is, the structural body 10 includes first plate-shaped portions 2A extending in the x-direction and first plate-shaped portions 2A extending in the y-direction. In the case of this structural body 10 having the sinusoidal lattice pattern, by changing the area to which bending stress is applied (the area on which a handle is mounted) and the direction of bending stress, a single-curved surface or multiple types of double-curved surfaces can be formed as the virtual surface Sr. That is, virtual surfaces Sr having various shapes can be formed.

### 5-2. Modification 2: Modification of Electrode Member 20

As shown in FIGS. 22A to 22D, an electrode member 20 includes a slit 20B1 formed by partially cutting away an inserted portion 20B. The slit 20B1 is used to insert a terminal for wiring the electrode member 20 inserted into the structural body 10. Cut portions 20B2 are formed on the inserted portions 20B, resulting in a reduction in the volume of the inserted portions 20B. Thus, the electrode member 20 is reduced in weight.

### 5-3. Other Forms

While, in the above embodiment, the electrostatic adsorption device 100 has been described as being configured to make a transition between a flat state and a curved state, this is not limiting. The electrostatic adsorption device 100 may be fixedly placed in a curved state. In this case, the structural body 10 includes a curved portion 10a. The electrostatic adsorption device 100 thus configured is suitable, for example, when there is a need for a electrostatic adsorption device specializing in gripping an object to be adsorbed having a curved surface with a predetermined shape.

The structural body 10 of the electrostatic adsorption device 100 according to the above embodiment may be configured to form curved portions in three or more directions simultaneously. That is, the structural body 10 has an additional curve direction other than the x- and y-directions in an x-y plane. The structural body 10 thus configured can easily cope with the complication of the surface of the object to be adsorbed.

While, in the above embodiment, the structural body 10 is configured to be curved with any constant curvature from one side to the other side in the x-direction , this is not limiting. For example, the structural body 10 may be configured to be curved complexly with a varying curvature from one side to the other side in the x-direction. The same also applies to a curve in the y-direction. Such a configuration can be achieved, for example, by making the configurations (sizes) of the housing portions 1 different rather than identical.

While, the above embodiment, the structural body 10 is configured to, when stress is applied thereto, form curves in multiple directions simultaneously, this is not limiting. The structural body 10 may be configured to form a curve only in one direction, as in the modification 1-2 described above.

Various embodiments will be described by way of example. Embodiments described below, Supplementary Notes 1 to 20, can be combined with each other.

### Supplementary Note 1

An electrostatic adsorption device 100 for electrostatically adsorbing an object to be adsorbed, comprising a structural body 10 and an electrode member 20,

> wherein the structural body 10 is configured to be at least partially deformed to form a curved portion 10a,
> wherein the curved portion 10a is curved from one side to another side in a first direction (x-direction),
> wherein the first direction is parallel to a plane perpendicular to a thickness direction (z-direction) of the structural body 10,
> wherein the electrode member 20 is disposed to be at least partially covered by the structural body 10 and has an adsorption surface 20A1 for electrostatically adsorbing the object to be adsorbed, and

wherein in a curved state in which the curved portion 10a is formed in the structural body 10, the adsorption surface 20A1 of the electrode member is located in a corresponding position along the curved portion 10a.

Supplementary Note 2

The electrostatic adsorption device 100 of Supplementary Note 1,

wherein the structural body 10 comprises a plurality of housing portions 1,
wherein the housing portions 1 each comprise a cavity 1A and a partition wall 1B,
wherein the cavity 1A contains the electrode member 20, and
wherein the partition wall 1B partitions the adjacent cavity 1A.

Supplementary Note 3

The electrostatic adsorption device 100 of Supplementary Note 2, wherein
the partition wall 1B is disposed to surround a lateral side of the electrode member 20.

Supplementary Note 4

The electrostatic adsorption device 100 of Supplementary Note 2 or 3, wherein
the cavities 1A are arranged to form a plane.

Supplementary Note 5

The electrostatic adsorption device 100 of any one of Supplementary Notes 2 to 4, wherein
the housing portions 1 each expose the adsorption surface 20A1 of the electrode member 20.

Supplementary Note 6

The electrostatic adsorption device 100 of any one of Supplementary Notes 1 to 5, wherein

wherein the structural body 10 comprises a plurality of first plate-shaped portions 2A and a plurality of second plate-shaped portions 2B,
wherein the first plate-shaped portions 2A are spaced from each other, and
wherein the second plate-shaped portions 2B are spaced from each other and are each connected to the pair of adjacent first plate-shaped portions 2A.

Supplementary Note 7

The electrostatic adsorption device 100 of Supplementary Note 6, wherein

the first plate-shaped portions 2A and/or the second plate-shaped portions 2B have wave shapes in a plan view of the structural body 10.

Supplementary Note 8

8. The electrostatic adsorption device 100 of Supplementary Note 6 or 7,

wherein the first plate-shaped portion 2Aare disposed to extend in the first direction,
wherein the second plate-shaped portion 2B are disposed to extend in a second direction, and
wherein the second direction is parallel to a plane perpendicular to the thickness direction of the structural body 10 and intersects the first direction.

Supplementary Note 9

The electrostatic adsorption device 100 of any one of Supplementary Notes 6 to 8, wherein
the first plate-shaped portions 2A and the second plate-shaped portions 2B differ in elasticity.

Supplementary Note 10

The electrostatic adsorption device 100 of any one of Supplementary Notes 1 to 9,

wherein the curved portion 10a is curved in the first direction, as well as from one side to another side in a second direction,
wherein the second direction is parallel to a plane perpendicular to a thickness direction of the structural body 10, and
wherein the first direction and the second direction intersect each other.

Supplementary Note 11

The electrostatic adsorption device 100 of Supplementary Note 10, wherein
the structural body 10 is configured to form a curve in the first direction and a curve in the second direction simultaneously.

Supplementary Note 12

The electrostatic adsorption device 100 of Supplementary Note 10 or 11, wherein
the structural body 10 is configured to, when tensile stress in the first direction is applied thereto, remain constant or expand in width in the second direction.

Supplementary Note 13

The electrostatic adsorption device 100 of any one of Supplementary Notes 1 to 12,

wherein the structural body 10 further comprises a force-acting portion 3, and
wherein the force-acting portion 3 is disposed at an edge of the structural body 10 and is configured to be coupled to a stress generation mechanism 30 configured to apply stress to deform the structural body 10.

Supplementary Note 14

The electrostatic adsorption device 100 of any one of Supplementary Notes 1 to 13,

wherein the structural body 10 is configured to make a transition between the curved state and a flat state, and
wherein when the structural body 10 is placed in the flat state, the adsorption surfaces 20A1 of the plurality of electrode members 20 are aligned in height.

Supplementary Note 15

The electrostatic adsorption device 100 of any one of Supplementary Notes 1 to 14, wherein the object to be adsorbed is a wafer or film.

Supplementary Note 16

The electrostatic adsorption device 100 of any one of Supplementary Notes 1 to 15, wherein the structural body 10 is made of a resin material or a metal material.

Supplementary Note 17

The electrostatic adsorption device 100 of any one of Supplementary Notes 1 to 3, wherein

wherein a difference in height between an uppermost adsorption surface and a lowermost adsorption surface is 10 cm or less,
wherein the uppermost adsorption surface is the adsorption surface in an uppermost position among the adsorption surfaces on the curved portion 10a, and
wherein the lowermost adsorption surface is the adsorption surface in a lowermost position among the adsorption surfaces on the curved portion 10a.

Supplementary Note 18

18. An electrostatic adsorption device 100 for electrostatically adsorbing an object to be adsorbed, comprising a structural body 10 and an electrode member 20,

wherein the structural body 10 includes a curved portion 10a,

wherein the curved portion 10a is curved from one side to another side in a first direction,
wherein the first direction is parallel to a plane perpendicular to a thickness direction of the structural body 10,
wherein the electrode member 20 is disposed to be at least partially covered by the structural body 10 and has an adsorption surface 20A1 for electrostatically adsorbing the object to be adsorbed, and
wherein the adsorption surface 20A1 of the electrode member 20 is located in a corresponding position along the curved portion 10a of the structural body 10.

Supplementary Note 19

19. A method for correcting a warp of the object to be adsorbed using the electrostatic adsorption device 100 of any one of Supplementary Notes 1 to 17, comprising:

an adsorption step of causing the adsorption surface 20A1 of the electrode member 20 of the structural body 10 in the curved state to adsorb the object to be adsorbed or causing the adsorption surface 20A1 of the electrode member 20 of the structural body 10 to adsorb the object to be adsorbed while causing the structural body 10 to make a transition to the curved state; and
a warp correction step of causing the structural body 10 to make a transition from the curved state to a flat state with the adsorption surface 20A1 adsorbing the object to be adsorbed, wherein
in the flat state, the plurality of adsorption surfaces 20A1 are aligned in height.

Supplementary Note 20

A method for mounting the object to be adsorbed using the electrostatic adsorption device 100 of any one of Supplementary Notes 1 to 18, comprising:

an adsorption step of causing the adsorption surface 20A1 of the electrode member 20 of the structural body 10 to adsorb the object to be adsorbed;
a deformation step of placing the structural body 10 in the curved state, wherein the deformation step is performed before, after, or concurrently with the adsorption step; and
a mounting step of mounting, on a destination object, the object to be adsorbed being adsorbed by the structural body 10 in the curved state.

Further embodiments are described as examples below. The embodiments shown below, Supplementary Notes 1 to 11, can be combined with each other.

Supplementary Note 1

An electrostatic adsorption device 100, wherein an electrode member 20 for electrostatic adsorption is supported by an extended auxetic structural body having a negative or zero Poisson's ratio configured to increase or remain constant in dimension in a direction perpendicular to a tensile direction (hereinafter referred to as the structural body 10).

Supplementary Note 2

The electrostatic adsorption device 100 of Supplementary Note 1,

wherein the structural body 10 is configured to form a main surface (virtual surface Sr) capable of making a transition between a flat surface and a curved surface or between a first curved surface and a second curved surface,
wherein the main surface (virtual surface Sr) constitutes a main surface (virtual surface Sr) of the electrostatic adsorption device 100, and
wherein the main surface (virtual surface) of the electrostatic adsorption device 100 is an electrostatic adsorption surface.

Supplementary Note 3

The electrostatic adsorption device 100 of Supplementary Note 1 or 2,

wherein the structural body 10 comprises an elastic element (first plate-shaped portion 2A) and a non-elastic element (second plate-shaped portion 2B), and
wherein the non-elastic element constrains deformation of the elastic element.

Supplementary Note 4

The electrostatic adsorption device 100 of Supplementary Note 3,

wherein the elastic element (first plate-shaped portion 2A) comprises a plurality of chevron-shaped elements elastically deformable at least in a first direction (x-direction) that is a length direction of the elastic element,
wherein the chevron-shaped elements are arranged in parallel in a second direction (y-direction) perpendicular to the first direction,
wherein the chevron-shaped elements are arranged such that peaks of one of the chevron-shaped elements, troughs of another chevron-shaped element adjacent to the one chevron-shaped element, and peaks of yet another chevron-shaped element adjacent to the another chevron-shaped element are aligned in the second direction,
wherein the non-elastic element couples the peaks or troughs of the one chevron-shaped element and the troughs or peaks of the another chevron-shaped element in the second direction, wherein there are maximum intervals between the peaks or troughs of the one chevron-shaped element and the troughs or peaks of the another chevron-shaped element, and
wherein the non-elastic element is coupled to the one chevron-shaped element and the another chevron-shaped element at an angle greater than 0° and less than 90°.

Supplementary Note 5

The electrostatic adsorption device 100 of Supplementary Note 3,

wherein the elastic element (first plate-shaped portion 2A) comprises a plurality of chevron-shaped elements elastically deformable at least in a first direction (x-direction) that is a length direction of the elastic element,
wherein the chevron-shaped elements are arranged in parallel in a second direction (y-direction) perpendicular to the first direction,
wherein peaks of one of the chevron-shaped elements and peaks of another chevron-shaped element adjacent to the one chevron-shaped element are aligned in the second direction and troughs of the one chevron-shaped element and troughs of the another chevron-shaped element are aligned in the second direction,
wherein the non-elastic element couples the peaks of the one chevron-shaped element and the peaks of the another chevron-shaped element on one side of the second direction, and
wherein the non-elastic element couples the troughs of the one chevron-shaped element and the troughs of the another chevron-shaped element on another side of the second direction.

Supplementary Note 6

The electrostatic adsorption device 100 of Supplementary Note 2,
wherein an electrostatic adsorption surface of the structural body 10 is configured to form a double-curved surface or a single-curved surface.

Supplementary Note 7

The electrostatic adsorption device 100 of Supplementary Note 1 or 2, further comprising drive means configured to apply bending stress to the structural body 10.

**Supplementary Note 8**

The electrostatic adsorption device 100 of Supplementary Note 2, wherein
when the main surface of the structural body 10 is configured to, when making a transition from a flat surface to a curved surface or from the first curved surface to the second curved surface, increase or remain constant in area.

**Supplementary Note 9**

An electrostatic adsorption method comprising:

electrostatically adsorbing a film using an electrostatic adsorption device 100;
transporting the film to a destination object; and
releasing the film onto a surface of the destination object,
wherein the electrostatic adsorption device 100 is the electrostatic adsorption device 100 of any one of Supplementary Notes 1 to 8, and
wherein the electrostatic adsorption method further comprises, during a period from when the electrostatic adsorption device 100 electrostatically adsorbs the film until the electrostatic adsorption device 100 releases the film onto the surface of the destination object, applying bending stress to an electrostatic adsorption surface of the electrostatic adsorption surface of the electrostatic adsorption device 100 to deform the electrostatic adsorption surface of the electrostatic adsorption device 100 into a curved surface to deform the electrostatically adsorbed film into a curved-surface shape.

**Supplementary Note 10**

The electrostatic adsorption method of Supplementary Note 9, wherein
the electrostatic adsorption surface of the electrostatic adsorption device 100 is deformed using a robot arm.

**Supplementary Note 11**

The electrostatic adsorption method of Supplementary Note 9 or 10, wherein
the structural body 10 included in the electrostatic adsorption device 100 is deformed such that the electrostatic adsorption surface of the structural body 10 increases or remains constant in area.

**Description of Reference Signs**

100: Electrostatic adsorption device, 10: Structural body, 10a: Curved portion, 1: Housing portion, 1A: Cavity, 1B: Partition wall, 1C: Cavity, 2: Plate-shaped portion, 2A: First plate-shaped portion (chevron-shaped element, high-elasticity portion, elastic element), 2A1: Inclined portion, 2A2: Protruding portion, 2A3: End surface, R1: First high-elasticity rod, R2: Second high-elasticity rod, R3: Third high-elasticity rod, R4: Fourth high-elasticity rod, R5: Fifth high-elasticity rod, 2B: Second Plate-shaped portion (low-elasticity portion, non-elastic element), 2B1: End surface, r1: First low-elasticity rod, r2: Second low-elasticity rod, r3: Third low-elasticity rod, r4: Fourth low-elasticity rod, r5: Fifth low-elasticity rod, 2C: Third plate-shaped portion, 2C1: End surface, 3: Force-acting portion, 20: Electrode member, 20A: Base portion, 20A1: Adsorption surface, 20B: Inserted portion, 20B1: Slit, 20B2: Cut portion, 20C: Cavity, 20a: Top portion, 30: Stress generation mechanism (drive means), 50: Voltage application device, Sr: Virtual surface

**Claims**

1. An electrostatic adsorption device for electrostatically adsorbing an object to be adsorbed, comprising a structural body and an electrode member,

wherein the structural body is configured to be at least partially deformed to form a curved portion,
wherein the curved portion is curved from one side to another side in a first direction, wherein the first direction is parallel to a plane perpendicular to a thickness direction of the structural body,
wherein the electrode member is disposed to be at least partially covered by the structural body and has an adsorption surface for electrostatically adsorbing the object to be adsorbed, and
wherein in a curved state in which the curved portion is formed in the structural body, the adsorption surface of the electrode member is located in a corresponding position along the curved portion.

2. The electrostatic adsorption device of claim 1,

wherein the structural body comprises a plurality of housing portions,
wherein the housing portions each comprise a cavity and a partition wall,
wherein the cavity contains the electrode member, and
wherein the partition wall partitions the adjacent cavity.

3. The electrostatic adsorption device of claim 2, wherein
the partition wall is disposed to surround a lateral side of the electrode member.

4. The electrostatic adsorption device of claim 2 or 3, wherein
the cavities are arranged to form a plane.

5. The electrostatic adsorption device of claim 2 or 3, wherein
the housing portions each expose the adsorption surface of the electrode member.

6. The electrostatic adsorption device of any one of claims 1 to 3, wherein

wherein the structural body comprises a plurality of first plate-shaped portions and a plurality of second plate-shaped portions,
wherein the first plate-shaped portions are spaced from each other, and
wherein the second plate-shaped portions are spaced from each other and are each connected to the pair of adjacent first plate-shaped portions.

7. The electrostatic adsorption device of claim 6, wherein
the first plate-shaped portions and/or the second plate-shaped portions have wave shapes in a plan view of the structural body.

8. The electrostatic adsorption device of claim 6,

wherein the first plate-shaped portions are disposed to extend in the first direction,
wherein the second plate-shaped portions are disposed to extend in a second direction, and
wherein the second direction is parallel to a plane perpendicular to the thickness direction of the structural body and intersects the first direction.

9. The electrostatic adsorption device of claim 6, wherein
the first plate-shaped portions and the second plate-shaped portions differ in elasticity.

10. The electrostatic adsorption device of any one of claims 1 to 3,

wherein the curved portion is curved in the first direction, as well as from one side to another side in a second direction,
wherein the second direction is parallel to a plane perpendicular to a thickness direction of the structural body, and
wherein the first direction and the second direction intersect each other.

11. The electrostatic adsorption device of claim 10, wherein
the structural body is configured to form a curve in the first direction and a curve in the second direction simultaneously.

12. The electrostatic adsorption device of claim 10, wherein
the structural body is configured to, when tensile stress in the first direction is applied thereto, remain constant or increase in width in the second direction.

13. The electrostatic adsorption device of any one of claims 1 to 3,

wherein the structural body further comprises a force-acting portion, and
wherein the force-acting portion is disposed at an edge of the structural body and is configured to be coupled to a stress generation mechanism configured to apply stress to deform the structural body.

14. The electrostatic adsorption device of any one of claims 1 to 3,

wherein the structural body is configured to make a transition between the curved state and a flat state, and
wherein when the structural body is placed in the flat state, the adsorption surfaces of the plurality of electrode members are aligned in height.

15. The electrostatic adsorption device of any one of claims 1 to 3, wherein
the object to be adsorbed is a wafer or film.

16. The electrostatic adsorption device of any one of claims 1 to 3, wherein
the structural body is made of a resin material or a metal material.

17. The electrostatic adsorption device of any one of claims 1 to 3, wherein

wherein a difference in height between an uppermost adsorption surface and a lowermost adsorption surface is 10 cm or less,
wherein the uppermost adsorption surface is the adsorption surface in an uppermost position among the adsorption surfaces on the curved portion, and
wherein the lowermost adsorption surface is the adsorption surface in a lowermost position among the adsorption surfaces on the curved portion.

18. An electrostatic adsorption device for electrostatically adsorbing an object to be adsorbed, comprising a structural body and an electrode member,

wherein the structural body includes a curved portion,
wherein the curved portion is curved from one side to another side in a first direction, wherein the first direction is parallel to a plane perpendicular to a thickness direction of the structural body, wherein the electrode member is disposed to be at least partially covered by the structural body and has an adsorption surface for electrostatically adsorbing the object to be adsorbed, and wherein the adsorption surface of the electrode member is located in a corresponding position along the curved portion of the structural body.

19. A method for correcting a warp of the object to be adsorbed using the electrostatic adsorption device of any one of claims 1 to 3, comprising:

an adsorption step of causing the adsorption surface of the electrode member of the structural body in the curved state to adsorb the object to be adsorbed or causing the adsorption surface of the electrode member of the structural body to adsorb the object to be adsorbed while causing the structural body to make a transition to the curved state; and a warp correction step of causing the structural body to make a transition from the curved state to a flat state with the adsorption surface adsorbing the object to be adsorbed, wherein in the flat state, the plurality of adsorption surfaces are aligned in height.

20. A method for mounting the object to be adsorbed using the electrostatic adsorption device of any one of claims 1 to 3 and 18, comprising:

an adsorption step of causing the adsorption surface of the electrode member of the structural body to adsorb the object to be adsorbed; a deformation step of placing the structural body in the curved state, wherein the deformation step is performed before, after, or concurrently with the adsorption step; and a mounting step of mounting, on a destination object, the object to be adsorbed being adsorbed by the structural body in the curved state.

FIG.1A

FIG.1B

FIG.2A

2

L

10

2A

2A

2C

2B

A

Y

X

FIG.2B

2

10

X

Y

FIG.2C

Rg1

10

Z

X

Rg2

FIG.3A

FIG.3B

FIG.4A

10

FIG.4B

2B

2A

2C

1

2A3

2B1

2C1

1A

1B

1B

1B

FIG.4C

2A1

2A2

2A3

1

1C

2A

2C

θ

2C1

2A

2B

2B1

2A

1A

2A1

2A2

FIG.5A

FIG.5B

FIG.6A

20a

20

20B 20B

FIG.6B

20

20A1

FIG.6C

20A 20

20B 20B

20C

FIG.6D

20

20A 20a

20A1

20B 20B

20C

FIG.7    EXAMPLE OF VIRTURAL CURVED SURFACE Sr
WHEN STRUCTURAL BODY 10 IS CURVED CONVEXLY

FIG.8A     STATE IN WHICH STRUCTURAL BODY 10
IS CURVED CONCAVELY

FIG.8B     ADSORPTION SURFACE OF
ELECTROSTATIC ADSORPTION DEVICE 100

FIG.8C     SURFACE OPPOSITE TO ADSORPTION SURFACE OF
ELECTROSTATIC ADSORPTION DEVICE 100

FIG.9A

FIG.9B

FIG.9C

FIG.10A

FIG.10B

FIG.10C
YET-TO-BE-DEFORMED
LOAD

FIG.10D
DEFORMED
LOAD

FIG.10E
DEFORMATION IS SUPPRESSED
BENDING STRESS
BENDING STRESS
DEFORMED SUCH THAT INTERNAL DIMENSION REMAINS CONSTANT

FIG.11A

0mm

FIG.11B

10mm

FIG.11C

20mm

FIG.12A

Flat

FIG.12B

FIG.12C

R200

FIG.12D

FIG.12E

R100

FIG.12F

FIG.13A 0mm

FIG.13B 10mm

FIG.13C 20mm

FIG.14A

Flat

FIG.14B

FIG.14C

R200

FIG.14D

FIG.14E

R100

FIG.14F

FIG.15

FIG.16A

FIG.16B

FIG.17A

FIG.17B

FIG.17C

FIG.17D

FIG.17E

FIG.17F

FIG.18A

l

10

X
Y

FIG.18C

l

10

X
Y

FIG.18E

l

10

X
Y

FIG.18B $\Delta l_a$

l

10

X
Y $\Delta l_a$

$\Delta l_t$          $\Delta l_t$

FIG.18D $\Delta l_a$

l

10

X
Y

$\Delta l_a$

FIG.18F $\Delta l_a$

l

10

X
Y

$\Delta l_a$

$\Delta l_t$          $\Delta l_t$

FIG.19A

2

10

2A

2B

3

FIG.19B

Y

X

10

122.41

2A  1  2B

Y

Z

129

A

3

3

10

Z

X

A (1:1)

Y

X

FIG.19C

1 (1A)

1

10

2A

2B

20

2.41

45°

EP 4 773 181 A1

FIG.20

43

FIG.21

FIG.22A

20D

C

45°

45°

6

3

3

B

FIG.22B

.75

20B1

20B

20B

20A

20C

4

2

8.09

2.41

8.09

18.59

FIG.22C

10

8.09

FIG.22D

20

20B

20B

20B2

20A

20B1

20B2

## INTERNATIONAL SEARCH REPORT

| International application No. |
|---|
| **PCT/JP2024/030734** |

| A. | CLASSIFICATION OF SUBJECT MATTER |
|---|---|

*H01L 21/683*(2006.01)i; *H02N 13/00*(2006.01)i; *H10K 59/10*(2023.01)i; *H10K 59/95*(2023.01)i; *H10K 71/00*(2023.01)i
FI:    H01L21/68 R; H02N13/00 D; H10K59/10; H10K59/95; H10K71/00

According to International Patent Classification (IPC) or to both national classification and IPC

| B. | FIELDS SEARCHED |
|---|---|

Minimum documentation searched (classification system followed by classification symbols)

    H01L21/683; H02N13/00; H10K59/10; H10K59/95; H10K71/00

Documentation searched other than minimum documentation to the extent that such documents are included in the fields searched

    Published examined utility model applications of Japan 1922-1996
    Published unexamined utility model applications of Japan 1971-2024
    Registered utility model specifications of Japan 1996-2024
    Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | WO 2023/022180 A1 (TOKYO INSTITUTE OF TECHNOLOGY) 23 February 2023 (2023-02-23) | 18 |
|   | paragraphs [0023]-[0024], [0064], [0116]-[0117], [0126]-[0127], [0130], fig. 5-6, 8 | |
| A | paragraphs [0023]-[0024], [0064], [0116]-[0117], [0126]-[0127], [0130], fig. 5-6, 8 | 1-17, 19-20 |
| A | JP 2023-029240 A (TOKYO INSTITUTE OF TECHNOLOGY) 03 March 2023 (2023-03-03) | 1-20 |
|   | entire text, all drawings | |
| A | WO 2017/150574 A1 (TOKYO INSTITUTE OF TECHNOLOGY) 08 September 2017 (2017-09-08) | 1-20 |
|   | entire text, all drawings | |
| A | HEATH, Callum J. C., NEVILLE, Robin M., SCARPA, Fabrizio, BOND, Ian P., POTTER, Kevin D., Morphing Hybrid honeycomb (MOHYCOMB) with in-situ Poission's ratio modulation, Smart Materials and Structures, 11 July 2016, vol. 25, no. 8, pp. 1-17, DOI: 10.1088/0964-1726/25/8/085008 | 1-20 |
|   | entire text, all drawings | |

☑ Further documents are listed in the continuation of Box C.        ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **27 September 2024** | **08 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

| International application No. |
| --- |
| **PCT/JP2024/030734** |

| C. | DOCUMENTS CONSIDERED TO BE RELEVANT | |
| --- | --- | --- |
| Category* | Citation of document, with indication, where appropriate, of the relevant passages | Relevant to claim No. |
| P, A | 吉本 純平, 田岡 祐樹, 齋藤 滋規, 双極型静電吸着デバイスの複曲面対応を目指したオーセティックパターンを用いた複曲面生成構造の開発, 2023年度精密工学会秋季大会学術講演会講演論文集, 31 August 2023, vol. 2023A, pp. 17-18, DOI: https://doi.org/10.11522/pscjspe.2023A.0_17, (YOSHIMOTO, Jumpei, TAOKA, Yuki, SAITO, Shigeki, Development of a Structure Using an Auxetic Pattern for Biconcave Surfaces in Bipolar Electrostatic Adsorption Devices), non-official translation (Proceedings of the 2023 JSPE Autumn Meeting)<br>entire text, all drawings | 1-20 |
| P, A | US 2024/0222182 A1 (INTEL CORPORATION) 04 July 2024 (2024-07-04)<br>entire text, all drawings | 1-20 |

Form PCT/ISA/210 (second sheet) (July 2022)

**INTERNATIONAL SEARCH REPORT**
**Information on patent family members**

International application No.

**PCT/JP2024/030734**

| Patent document cited in search report | | | Publication date (day/month/year) | Patent family member(s) | | | Publication date (day/month/year) |
|---|---|---|---|---|---|---|---|
| WO | 2023/022180 | A1 | 23 February 2023 | CN | 117837075 | A | |
| JP | 2023-029240 | A | 03 March 2023 | KR 10-2023-0028161 | | A | |
| WO | 2017/150574 | A1 | 08 September 2017 | (Family: none) | | | |
| US | 2024/0222182 | A1 | 04 July 2024 | EP | 4394855 | A2 | |
| | | | | entire text, all drawings | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007109827 A